(19) Europäisches Patentamt
European Patent Office
Office européen des brevets

(11) EP 4 718 091 A1

(12) # EUROPÄISCHE PATENTANMELDUNG

(43) Veröffentlichungstag:
**01.04.2026 Patentblatt 2026/14**

(21) Anmeldenummer: **24203017.9**

(22) Anmeldetag: **26.09.2024**

(51) Internationale Patentklassifikation (IPC):
***G01R 31/367*** (2019.01) ***G01R 31/382*** (2019.01)
***G01R 31/392*** (2019.01) ***H01M 8/04298*** (2016.01)
***H01M 8/04537*** (2016.01) ***H01M 8/04664*** (2016.01)
***H01M 8/04992*** (2016.01)

(52) Gemeinsame Patentklassifikation (CPC):
**G01R 31/367; G01R 31/382; G01R 31/392; H01M 8/04305; H01M 8/04544; H01M 8/04552; H01M 8/04559; H01M 8/04664; H01M 8/04992**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Zentrum für Sonnenenergie- und Wasserstoff-Forschung Baden-Württemberg Gemeinnützige Stiftung**
**70563 Stuttgart (DE)**

(72) Erfinder:
- **Klass, Lukas**
  **70563 Stuttgart (DE)**
- **Kabza, Alexander**
  **70563 Stuttgart (DE)**
- **Sehnke, Frank**
  **70563 Stuttgart (DE)**
- **Holz, Laurin**
  **70563 Stuttgart (DE)**

(74) Vertreter: **Ter Meer Steinmeister & Partner Patentanwälte mbB**
**Nymphenburger Straße 4**
**80335 München (DE)**

Bemerkungen:
Geänderte Patentansprüche gemäss Regel 137(2) EPÜ.

(54) **VERFAHREN, VORRICHTUNG UND SYSTEM ZUM ÜBERWACHEN EINER ELEKTROCHEMISCHEN ANLAGE**

(57) Nach einem Aspekt der Erfindung wird ein Überwachungsmodell zur Überwachung einer elektrochemischen Anlage, insbesondere einer Brennstoffzelle, bereitgestellt. Das Verfahren umfasst ein Erfassen von Betriebsdaten der elektrochemischen Anlage als Trainingsdaten. Das Verfahren umfasst ein Trainieren eines ersten neuronalen Prädiktors basierend auf den Trainingsdaten zum Vorhersagen einer Zellspannung. Der erste neuronale Prädiktor repräsentiert einen stationären Betrieb der elektrochemischen Anlage. Das Verfahren umfasst ein Trainieren eines zweiten neuronale Prädiktors basierend auf den Trainingsdaten zum Vorhersagen eines Alterungseinflusses auf die Zellspannung der elektrochemischen Anlage. Der erste neuronale Prädiktor und/oder der zweite neuronale Prädiktor werden ausgehend von einem jeweiligen Basismodell trainiert. Der erste neuronale Prädiktor und/oder der zweite neuronale Prädiktor sind jeweils eingerichtet, einen Ausgangswert zu erzeugen. Das Verfahren umfasst ferner ein Bereitstellen des Überwachungsmodells, das den ersten neuronale Prädiktor, den zweiten neuronale Prädiktor und eine Verknüpfung derer Ausgangswerte umfasst.

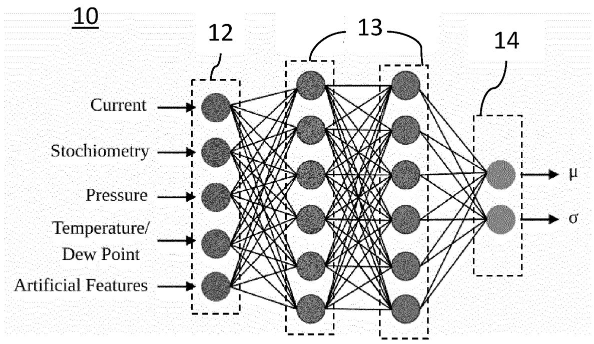


Fig. 3

EP 4 718 091 A1

## Beschreibung

Die vorliegende Erfindung betrifft ein Verfahren und eine Vorrichtung zum Bereitstellen eines Überwachungsmodells zur Überwachung einer elektrochemischen Anlage, ein Verfahren und ein System zum Erkennen einer Anomalie in einem Betrieb einer elektrochemischen Anlage, und ein entsprechendes Computerprogramm sowie einen entsprechenden computerlesbaren Datenträger. Die elektrochemische Anlage kann bevorzugt eine Brennstoffzelle sein.

## Technischer Hintergrund

Die Elektrifizierung und die Nutzung von Wasserstoff als Energieträger in elektrochemischen Anlagen sind Schlüsselstrategien für den Erfolg der globalen Energiewende hin zu erneuerbaren Energiequellen. Die hohe Energiedichte und das Vorkommen von Wasserstoff machen ihn zu einem idealen Speichermedium für die schwankende Verfügbarkeit erneuerbarer Energien. Darüber hinaus können elektrochemische Anlagen, wie beispielsweise Brennstoffzellen, die im Wasserstoff gespeicherte chemische Energie in elektrische Energie umwandeln und so die Elektrifizierung von Anwendungen ermöglichen, bei denen eine direkte Elektrifizierung nicht möglich ist und Batterien entweder unzureichend oder in ihrer Kapazität begrenzt sind. Im Gegensatz zu Batterien erfordern derartige Anlagen viele periphere Komponenten und die Kontrolle mehrerer Betriebsparameter, was das Risiko eines Komponentenausfalls erhöht. Darüber hinaus sind diese Anlagen als offene Systeme anfällig für das Einbringen von Verunreinigungen aus externen Quellen. Dies unterstreicht die Bedeutung der Überwachung für den zuverlässigen Langzeitbetrieb derartiger elektrochemischer Anlagen, insbesondere Brennstoffzellen.

Üblicherweise werden Brennstoffzellen mit konstanten Alarmschwellen überwacht, wodurch jedoch nur extreme Ereignisse erkannt werden können und die Brennstoffzelle vor dauerhaften Schäden geschützt werden kann. Langsam fortschreitende Ausfälle und/oder Kontaminationen der Reaktanten können hingegen nicht direkt erfasst werden, sondern spiegeln sich nur in der Zellspannung der Brennstoffzelle wider. Aufgrund der mannigfaltigen Einflüsse auf die Zellspannung der Brennstoffzelle, bleiben diese Art von Anomalien üblicherweise unerkannt. Da die Zellspannung einer Brennstoffzelle nicht nur auf nichtlineare Weise von den Betriebsbedingungen abhängt, sondern auch von der Betriebshistorie der Brennstoffzelle, kann der schwellenwertbasierte Ansatz diese Art von Anomalien in den Messungen nicht erkennen. Für die Überwachung der Zellenspannung werden anspruchsvollere Algorithmen benötigt, die eine genaue Vorhersage der Zellenspannung ermöglichen.

Methoden des maschinellen Lernens sind aufgrund ihrer Fähigkeit, nichtlineare Zusammenhänge aus Daten zu lernen, ohne dass eine physikalische Beschreibung des Problems erforderlich ist, ein vielversprechender Ansatz für die Brennstoffzellenüberwachung. Aufgrund der Komplexität des Betriebs einer Brennstoffzelle, sind hinreichend große Trainingsdatensätze erforderlich, um maschinelle Lernprozesse für die Überwachung der Brennstoffzelle vorzubereiten. Beispielsweise beschreibt Klass, et al., "Lifelong performance monitoring of PEM fuel cells using machine learning models", Journal of Power Sources, Volume 580, 2023, 233308, ISSN 0378-7753, ein Verfahren zum Überwachen einer Brennstoffzelle mittels eines neuronalen Netzes, das als digitaler Zwilling agiert. Das neuronale Netz ist long short-term memory (LSTM)-basiert und wurde basierend auf 3500 Stunden Brennstoffzellenbetriebsdaten trainiert. Der digitale Zwilling konnte dadurch den Spannungsverlauf einer Brennstoffzelle über einen langen Zeitraum mit Alterungseffekten der Brennstoffzelle präzise vorhersagen.

In der Praxis hat sich jedoch herausgestellt, dass das trainierte neuronale Netz für jede Brennstoffzelle separat trainiert werden musste, da ein Übertrag eines vortrainierten neuronalen Netzes von einer Brennstoffzelle auf eine andere Brennstoffzelle eine umfangreiche Anpassung des neuronalen Modells erfordern würde. Ferner wurde festgestellt, dass die 3500 Stunden Betriebsdaten einer Brennstoffzelle zwar viele Datenpunkte beinhalten, doch im Vergleich hierzu relativ wenig Information, die auf wenige, durch das Prüfprofil definierte, Belastungspunkte beschränkt ist.

## Zusammenfassung

Es ist daher eine Aufgabe der vorliegenden Erfindung, ein Überwachungsmodell zur Überwachung der Zellspannung in einer Brennstoffzelle bereitzustellen, das einfacher, schneller und mit weniger Aufwand bereitstellbar ist, ohne jedoch Qualitätseinbußen bei der Vorhersage der Zellspannung hinnehmen zu müssen. Ferner besteht ein Bedarf an einem Verfahren, das ein Überwachungsmodell für Brennstoffzellen effizient auf neue Brennstoffzellen anpassen kann. Ferner besteht die Nachfrage nach einem weniger komplexen Modell zur Vorhersage der Zellspannung einer Brennstoffzelle, das auch Alterungseffekte berücksichtigt. Eine weitere Aufgabe der Erfindung liegt in der Bereitstellung entsprechender Computerprogramme bzw. Programmcodes zur Durchführung der Verfahren.

Zumindest eine dieser Aufgaben wird durch eines der Verfahren, der Vorrichtung, des Systems und/oder des Computerprogramms bzw. des Datenträgers mit Programmcode zum Überwachen einer elektrochemischen Anlage nach einem der unabhängigen Ansprüche gelöst. Weiterbildungen der Erfindung sind in den jeweiligen abhängigen Ansprüchen angegeben.

Nach einem Aspekt der Erfindung wird ein Überwachungsmodell zur Überwachung einer elektrochemischen Anlage, insbesondere einer Brennstoffzelle, bereitgestellt. Das Verfahren umfasst ein Erfassen von Betriebsdaten der elektrochemischen Anlage als Trainingsdaten. Das Verfahren umfasst ein Trainieren eines ersten neuronalen Prädiktors basierend auf den Trainingsdaten zum Vorhersagen einer Zellspannung. Der erste neuronale Prädiktor repräsentiert einen stationären Betrieb der elektrochemischen Anlage. Das Verfahren umfasst ein Trainieren eines zweiten neuronale Prädiktors basierend auf den Trainingsdaten zum Vorhersagen eines Alterungseinflusses auf die Zellspannung der elektrochemischen Anlage. Der erste neuronale Prädiktor und/oder der zweite neuronale Prädiktor werden ausgehend von einem jeweiligen Basismodell trainiert. Der erste neuronale Prädiktor und/oder der zweite neuronale Prädiktor sind jeweils eingerichtet, einen Ausgangswert zu erzeugen. Das Verfahren umfasst ferner ein Bereitstellen des Überwachungsmodells, das den ersten neuronale Prädiktor, den zweiten neuronale Prädiktor und eine Verknüpfung derer Ausgangswerte umfasst.

Als neuronale Prädiktor wird ein probabilistisches Modell bezeichnet, das ein oder mehrere maschinelle Lernmodelle, insbesondere neuronale Netze umfasst. Der Ausgangswert eines neuronalen Prädiktors ist demnach eine Wahrscheinlichkeitsaussage über einen bestimmten Wert der Zellspannung der elektrochemischen Anlage bzw. Brennstoffzelle.

Das Basismodell (engl. Foundation Model) kann ein vorbereitetes, voll funktionsfähiges probabilistisches Modell sein, dessen Training jedoch keine der von der Brennstoffzelle erfassten Betriebsdaten umfasst. Das Basismodell ist mit anderen Trainingsdaten vortrainiert, wie nachfolgend erläutert. Das Basismodell kann dieselbe Struktur bzw. Architektur wie der jeweilige neuronale Prädiktor aufweisen, d.h., ein erstes Basismodell kann der Architektur des ersten neuronalen Prädiktors entsprechen und ein zweites Basismodell kann der Architektur des zweiten neuronalen Prädiktors entsprechen.

Das Trainieren des ersten neuronalen Prädiktors und/oder des zweiten neuronalen Prädiktors ausgehend von dem entsprechenden Basismodell kann auch als Lerntransfer (engl. Transfer Learning) bezeichnet werden. Mit anderen Worten können die im Basismodell angelegten nichtlinearen Zusammenhänge zwischen mehreren physikalischen Eingangsvariablen und der Zellspannung der Brennstoffzelle durch das Trainieren mit den neu erfassten Trainingsdaten einer bestimmten Brennstoffzelle auf diese Brennstoffzelle angepasst bzw. verfeinert werden. Das Basismodell kann dieselben internen Parameter aufweisen wie der entsprechende neuronale Prädiktor, wobei die internen Parameter des Basismodells durch ein entsprechendes Training vorbestimmt sind. Die internen Parameter können Gewichte, Bias sowie Hyperparameter umfassen. Anders als bei einer zufälligen Initialisierung der Gewichte, Bias und/oder Hyperparameter zu Beginn eines Trainings können die internen Parameter des ersten neuronalen Prädiktors und/oder des zweiten neuronalen Prädiktors die vorbestimmten Parameterwerte des jeweiligen Basismodells übernehmen bzw. nur noch leicht anpassen.

Das erfindungsgemäße Überwachungsmodell ist erheblich weniger komplex als das vorbekannte LSTM-basierende Modell, da es die Vorhersage der Zellspannung auf den ersten neuronalen Prädiktor und den zweiten neuronalen Prädiktor, also zwei Teilmodelle, aufteilt. Dazu können der erste neuronale Prädiktor und der zweite neuronale Prädiktor unabhängig voneinander und insbesondere parallel trainiert werden. Jeder der beiden neuronalen Prädiktoren kann für sich genommen weniger komplex als ein einziges Modell zur Überwachung der Zellspannung einer Brennstoffzelle ausgebildet sein. Der erste neuronale Prädiktor kann beispielsweise ausschließlich stationäre Zusammenhänge zwischen den mehreren physikalischen Eingangsvariablen und der Zellspannung abbilden, und zeitabhängige Alterungseffekte vernachlässigen. Der zweite neuronale Prädiktor hingegen kann abstrahiert von den stationären Zusammenhängen eine Korrektur der vorhergesagten Zellspannung aufgrund von Zeiteffekten vorhersagen. Insbesondere der zweite neuronale Prädiktor kann somit erheblich weniger Eingangsvariablen benötigen, wodurch die Menge an benötigten Trainingsdaten im Gegensatz zum bekannten LSTM-Modell erheblich reduziert werden kann.

Aufgrund des Lerntransfers können ausgehend von einem vorbereiteten Basismodell erheblich weniger Trainingsdaten benötigt werden um jeweils den ersten neuronalen Prädiktor und/oder den zweiten neuronalen Prädiktor an eine neue Brennstoffzelle anzupassen, als das Trainieren des jeweiligen neuronalen Prädiktors von Grund auf, also basierend auf einer zufälligen Initialisierung seiner Parameter, benötigen würde.

Der Alterungseinfluss, nachfolgend auch als Degradation bezeichnet, betrifft einen, insbesondere allmählichen, Rückgang der Funktionalität der Brennstoffzelle, beispielsweise aufgrund von Verschleiß, Alterungsprozessen, Ablagerungen oder dergleichen.

Mit anderen Worten hängt die Zellspannung einer Brennstoffzelle sowohl von den aktuellen Betriebsbedingungen als auch von vergangenen Ereignissen und Lastzyklen ab, die eine reversible und irreversible Degradation verursachen. Um diese unterschiedlichen Phänomene zu berücksichtigen, stellt das erfindungsgemäße Überwachungsmodell einen digitalen Zwilling der zweiten Generation bereit, der ein stationäres Brennstoffzellenmodell und ein Degradationsmodell umfasst. Im Gegensatz zum komplexen Einzelmodell-Ansatz des digitalen Zwillings der ersten Generation ermöglicht dieser Ansatz die Verwendung von weniger komplexen Maschinellen Lernmodellen. Diese Verringerung der Komplexität reduziert nicht nur die Menge der erforderlichen Trainingsdaten erheblich, sondern ermöglicht auch eine robuste Übertragung der beiden vortrainierten Modelle auf neue Brennstoffzellen.

In einer Ausgestaltung kann das Verfahren ferner umfassen: Trainieren des ersten neuronalen Prädiktors ausgehend von einem ersten Basismodell, das erste Parameter umfasst. Die ersten Parameter können auf Realdaten und/oder einer Simulation der elektrochemischen Anlage ermittelt sein.

Die ersten Parameter können interne Parameter des ersten Basismodells sein.

Die Simulation kann ein physikbasiertes Modell zur Simulation der elektrochemischen Prozesse in der Brennstoffzelle umfassen, das basierend auf mehreren physikalischen Eingangsvariablen die Zellspannung der Brennstoffzelle unter stationären Bedingungen ermitteln kann. Die Simulation kann eine genaue und schnelle Vorhersage der Zellspannung für einen bestimmten stationären Betriebspunkt liefern. Die physikalischen Eingangsvariablen der Simulation sind vorzugsweise dieselben wie diejenigen des ersten Basismodells und/oder des ersten neuronalen Prädiktors.

Das physikbasierte Modell kann Kathoden- und/oder Anodenseitige Spannungseffekte, eine Stoffaustauschapproximation, und eine Modellierung des Membranwiderstands umfassen. Die Stromdichteverteilung in der Brennstoffzelle kann entlang des Hauptkanals segmentiert ermittelt werden, basierend auf unterschiedlichen Mischungszustände der Reaktanten, Temperaturen und/oder Drücken. Das physikbasierte Modell kann zwischen einem Mitstrom- und einem Gegenstrom-Betrieb unterscheiden. Vorzugsweise kann die Zellspannung für jedes Segment wie folgt berechnet werden:

$$U\left(j\right) = E - U_{act,c,a}\left(j\right) - U_{ohm}\left(j\right) - U_{trans,c,a}\left(j\right)$$

Hierbei bezeichnet *U(j)* die Zellspannung für die Stromdichte *j, E* eine korrigierte Leerlaufspannung, z.B., basierend auf der Nernst-Gleichung, $U_{act}$ die Aktivierungsüberspannung, die z.B. basierend auf der Butler-Volmer-Methode für die Anode und die Kathode berechnet werden kann, $U_{trans}$ einen approximierten Stoffaustausch in der Gasdiffusionsschicht für Anode und Kathode, und $U_{ohm}$ der Spannungsverlust aufgrund Brennstoffzellen-interner Widerstände, beispielsweise der Membran.

Die Berechnung durch das physikbasierte Modell kann mit einem vom Benutzer angegebenen Zielstrom beginnen. Dieser Strom wird verwendet, um eine vorläufige Schätzung der Zellspannung zu berechnen. Dieser Schätzwert kann verwendet werden, um einen Strom für jedes einzelne Segment der Brennstoffzelle zu berechnen. Da sich die Betriebsbedingungen (Feuchtigkeit, Reaktantenkonzentration, Druck und Temperatur) in jedem Segment ändern, variiert auch der Strom pro Segment bei einer gegebenen Zellspannung. Sobald alle Segmente berechnet wurden, wird der Durchschnittsstrom mit dem benutzer-definierten Zielstrom verglichen. Um Konvergenz zu erreichen, kann die Spannung iterativ angepasst werden, bis der Zielstrom und der berechnete Strom gleich sind. Wenn diese Bedingung erfüllt ist, erhält man ein Ergebnis für die angegebenen Betriebsbedingungen.

Für einen einzelnen Betriebspunkt bzw. Datenpunkt kann die Simulation ein Ergebnis in Sekundenbruchteilen ermitteln. Die Simulation basierend auf dem physikbasierten Modell kann daher generische Trainingsdaten erheblich schneller erzeugen als herkömmliche Verfahren, wonach Betriebsdaten einer Brennstoffzelle erfasst werden. Zudem berücksichtigt das physikbasierte Modell keinerlei Alterungseinflüsse, sodass die generischen Trainingsdaten zum Training eines rein stationären Prädiktors der Zellspannung besser geeignet sind als Betriebsdaten, die inhärent Alterungseffekte der Brennstoffzelle aufweisen.

In einer Ausgestaltung kann die elektrochemische Anlage eine Brennstoffzelle sein. Die Simulation kann eingerichtet sein, für mehrere diskretisierte Zellsegment jeweils eine Spannung basierend auf mehreren physikalischen Eingangsvariablen zu ermitteln, und eine Zellspannung der Brennstoffzelle basierend auf den Spannungen der Zellsegmente zu ermitteln.

Die mehreren Zellsegmente ermöglichen ein räumliches Diskretisieren einer Brennstoffzelle, insbesondere entlang des Hauptkanals, wie vorstehend beschrieben.

In einer Ausgestaltung können die mehreren physikalischen Eingangsvariablen aus einer Gruppe ausgewählt sein. Die Gruppe kann umfassen:

Strom,
stöchiometrischer Mindeststrom,
Stöchiometrie an Anode und/oder Kathode,
Eingangsdruck an Anodenseite und/oder Kathodenseite,
Ausgangsdruck an Anodenseite und/oder Kathodenseite,
Einlasstemperatur eines Kühlmittels,
Auslasstemperatur des Kühlmittels,
Wasserstoffanteil,
Sauerstoffanteil.

Neben den physikalischen Eingangsvariablen umfasst die Simulation weitere Modellparameter, die initial vorzugsweise einmalig ermittelt werden können, etwa durch Anfitten an Realdaten einer Brennstoffzelle und im Verlauf

der Simulation konstant gehalten werden. Somit ist die Simulation eingerichtet, für die physikalischen Eingangsvariablen, die im Wesentlichen die Betriebsbedingungen einer realen Brennstoffzelle entsprechen, jeweilige Spannungen der diskretisierten Zellsegmente bzw. die Zellspannung der Brennstoffzelle zu ermitteln. Durch geschicktes Abtasten bzw. Verändern der physikalischen Eingangsparameter kann ein hinreichend realistisches Betriebsbedingungsspektrum simuliert werden.

In einer Ausgestaltung kann die Simulation eingerichtet sein, durch Abtasten von Werten für die mehreren physikalischen Eingangsvariablen Trainingsdaten für eine Vielzahl von Betriebsbedingungen zum Ermitteln der ersten Parameter des ersten Basismodells zu erzeugen, vorzugsweise durch einen gleichmäßig abgetasteten Strom oder durch eine gleichmäßige Verteilung der ermittelten Zellspannung.

Hierbei ist zu beachten, dass die Betriebsbedingungen für eine Brennstoffzelle typischerweise nicht frei gewählt werden können, sondern oft voneinander abhängig sind, um einen stabilen Betrieb der Brennstoffzelle zu gewährleisten. Zum Beispiel sollte die relative Luftfeuchtigkeit am Kathodenausgang 100 % nicht wesentlich überschreiten, um eine Wasserüberflutung zu vermeiden, was wiederum die Temperatur und den Taupunkt einschränkt. Ein gleichmäßiges Abtasten des Stroms bzw. eine gleichmäßige Verteilung der ermittelten Zellspannung innerhalb vorbestimmter Randbedingungen der weiteren physikalischen Eingangsparameter gewährleistet ausschließlich ausführbare Betriebsbedingungen für Brennstoffzellen in den künstlich generierten Trainingsdaten. Die vorbestimmten Randbedingungen können diskrete Werte und/oder Bereichsangaben für die einzelnen physikalischen Eingangsparameter umfassen.

Aus einem gleichmäßigen Abtasten des Stroms kann eine ungleichmäßige Verteilung der Spannungswerte resultieren. Dadurch können unterschiedliche Spannungsbereiche in den erzeugten Trainingsdaten ungleichgewichtet sein.

Daher kann es vorteilhaft sein, die Trainingsdaten basierend auf einer gleichmäßigen Verteilung der Spannungswerte zu erzeugen. Dazu kann das Strom-Spannungsverhältnis für ermittelte Stromwerte herangezogen werden. Brennstoffzellen weisen üblicherweise ein logarithmisch-linear-exponentielles Strom-Spannungsverhältnis auf. Aus ermittelten Strom-Spannungspaaren können diejenigen Stromwerte numerisch geschätzt werden, die gleichverteilten Spannungswerten zugeordnet sind, etwa durch eine numerische Approximation einer Umkehrfunktion einer angefitteten Brennstoffzellen-Polarisationskurve basierend auf den Strom-Spannungspaaren.

In einer Ausgestaltung können die Trainingsdaten mehrere Merkmalsvektoren umfassen, die jeweils einen Datenpunkt repräsentieren. Die Trainingsdaten können eine vorbestimmte Anzahl physikalischer Eingangsmerkmale und einen dazu korrespondierenden Spannungswert umfassen. Das Verfahren kann ferner umfassen: Erzeugen der physikalischen Eingangsmerkale durch Transformieren der physikalischen Eingangsvariablen der Simulation.

Beispielsweise können die vorstehend aufgelisteten physikalischen Eingangsparameter der Simulation in folgende Liste von Eingangsmerkmale für das erste Basismodell und/oder den ersten neuronalen Prädiktor transformiert werden:

(Relativer) Kathodeneinlassdruck (bar),
(Relativer) Anodeneinlassdruck (bar),
Stöchiometrie der Anode,
Stöchiometrie der Kathode,
Kühlmitteleinlasstemperatur (°C),
Kühlmittelauslasstemperatur (°C),
Stickstoffkonzentration der Anode (%),
Taupunkttemperatur des Kathodeneinlasses (°C),
Taupunkttemperatur des Anodeneinlasses (°C),
Stromdichte ($Acm^{-2}$), und
optional: minimale stöchiometriebedingte Stromdichte ($Acm^{-2}$),
sowie Kombinationen hiervon und/oder den mehreren physikalischen Eingangsparametern der Simulation.

Vorzugsweise können die Eingangsmerkmale in ein neuronales Netz des Basismodells und/oder des ersten neuronalen Prädiktors in vorstehender Reihenfolge eingegeben werden.

In einer Ausgestaltung kann der erste neuronale Prädiktor zumindest ein erstes neuronales Netz umfassen. Das erste neuronale Netz kann in einer ersten Schicht mehrere Eingangsknoten aufweisen, die jeweils ein physikalisches Eingangsmerkmal repräsentieren. Das erste neuronale Netz kann mehrere verborgene Schichten aufweisen, die jeweils mehrere neuronale Knoten umfassen. Für jede verborgene Schicht kann ein gewichteter Mittelwert basierend auf allen Knoten der vorherigen Schicht ermittelt werden. Das erste neuronale Netz kann eine Ausgangsschicht aufweisen, die eine Wahrscheinlichkeitsverteilung für die Zellspannung repräsentiert.

Ein neuronales Netz ist ein mathematisches Modell, das von der Struktur des menschlichen Gehirns inspiriert ist. Es kann aus miteinander verbundenen Neuronen bestehen, die in verschiedenen Schichten organisiert sind. Die mehreren physikalischen Eingangsmerkmale werden in die erste Schicht bzw. Eingabeschicht eingespeist. Jedes

Neuron in der ersten verborgenen Schicht kann die von der vorherigen Schicht erhaltenen Informationen verarbeiten, indem es eine gewichtete Summe seiner Eingaben berechnet und einen Vorspannungsterm bzw. Bias hinzufügt. Die Summe wird dann durch eine Aktivierungsfunktion transformiert. Dadurch wird Nichtlinearität in das Netz eingeführt, so dass es komplexe Muster in den Daten lernen kann. Die Informationen werden dann auf die gleiche Weise durch die übrigen verborgenen Schichten weitergegeben, bis sie die letzte Schicht, die Ausgabeschicht bzw. Ausgangsschicht, erreichen. Um eine probabilistische Vorhersage zu erhalten, wird dem Modell eine Gaußsche Ausgangsschicht hinzugefügt, die den Mittelwert $\mu$ und die Standardabweichung $\sigma$ der Gaußschen Verteilung des Vorhersageziels vorhersagt. Da die Zellspannung einer Brennstoffzelle unimodal verteilt ist, reicht eine einzige Gauß-Verteilung aus.

Das linearen Strom-Spannungsverhältnisses von Brennstoffzellen kann zu numerischen Instabilitäten beim Training eines vollvernetzten neuronalen Netzes führen, was die Genauigkeit des neuronalen Netzes verschlechtern kann. Daher kann ein künstliches Eingangsmerkmal, das eine modifizierte Stromdichte repräsentiert, zusätzlich zu den mehreren physikalischen Eingangsvariablen der Simulation vorgesehen sein. Die modifizierte Stromdichte kann beispielsweise eine linearisierte Stromdichte sein, mittels der die logarithmische Abhängigkeit von der Zellspannung reduziert werden kann. Basierend auf der linearisierten Stromdichte kann die Genauigkeit des neuronalen Netzes verbessert werden.

Ferner kann eine virtuelle Stromdichte als zusätzliche künstliches Eingangsmerkmal vorgesehen sein. Die virtuelle Stromdichte kann eine minimale Stromdichte repräsentieren, die für die Berechnung des Gasflusses bei realen Stromdichten, die kleiner als die virtuelle Stromdichte sind, herangezogen werden.

Nach dem Training des ersten neuronalen Netzes bzw. des ersten neuronalen Prädiktors mit den simulierten Trainingsdaten kann ein kleiner Datensatz mit weniger als 100 Datenpunkten für das Transferlernen verwendet werden, um das vortrainierte Modell an die zu überwachende Brennstoffzelle anzupassen und bereitzustellen.

In einer Ausgestaltung kann das Verfahren ferner umfassen: Trainieren des zweiten neuronalen Prädiktors ausgehend von einem zweiten Basismodell, das zweite Parameter umfasst. Die zweiten Parameter können basierend auf einem Datensatz vergangener Betriebsdaten oder Simulationsdaten von einer Anzahl von Brennstoffzellen ermittelt sein.

Die Vorteile des Trainings des zweiten neuronalen Prädiktors basierend auf dem zweiten Basismodell im Vergleich zu einem vollumfänglichen Trainieren des zweiten neuronalen Prädiktors ausgehend von einer Zufallsinitialisieren der internen Parameter ergeben sich in analoger Weise wie für den ersten neuronalen Prädiktor. Insbesondere kann die notwendige Anzahl von Trainingsdaten erheblich reduziert werden. Nachdem die Degradation einer Brennstoffzelle tendenziell eher von makroskopischen Parametern zum Betrieb der Brennstoffzelle als von mikroskopischen Parametern zu den elektrochemischen Prozessen in der Brennstoffzelle abhängt, kann das zweite Basismodell vorteilhafterweise auf Basis von vergangenen Realdaten einer Brennstoffzelle trainiert werden.

Das Degradationsmodell (zweiter neuronaler Prädiktor) kann die Vorhersagen des stationären Brennstoffzellenmodells (erster neuronaler Prädiktor) korrigieren, indem es zeitabhängige Brennstoffzelleneffekte wie reversible und irreversible Degradation berücksichtigt. In Kombination mit den Vorhersagen des stationären Modells führt die Degradationsvorhersage zu einer genauen Vorhersage der degradierten Zellspannung auf der Grundlage aktueller und früherer Betriebsbedingungen, einschließlich früherer Ereignisse.

In einer Ausgestaltung kann der zweite neuronale Prädiktor zumindest ein zweites neuronales Netz umfasst, das eine Gedächtnisfunktion enthält, beispielsweise LSTM, eine gated recurrent unit (GRU) oder Transformer. Das zweite neuronale Netz kann eine Ausgangsschicht aufweisen, die eine Wahrscheinlichkeitsverteilung für einen Alterungseinflusswert auf die Zellspannung der elektrochemischen Anlage, bevorzugt Brennstoffzelle, repräsentiert.

Der Einsatz einer Gedächtnisfunktion im zweiten neuronalen Prädiktor ist vorteilhaft, da sich die Degradation der Zellspannung im Laufe der Zeit entwickelt und daher in hohem Maße von der vergangenen Betriebsgeschichte der Brennstoffzelle abhängt. Die rekurrenten Einheiten des LSTM bzw. GRU ermöglichen es dem zweiten neuronalen Prädiktor, sich an vergangene Ereignisse wie Starts und Abschaltungen zu erinnern, um sie für künftige Vorhersagen zu nutzen. Auch das zweite neuronale Netz kann eine Gaußsche Ausgangsschicht umfassen, um eine probabilistische Vorhersage zu erhalten.

Im Vergleich zu dem LSTM-Modell des digitalen Zwillings der ersten Generation kann der zweite neuronale Prädiktor im Wesentlichen ausschließlich auf zeitabhängige Phänomene fokussiert sein und stationäre Effekte außer Acht lassen. Dadurch können weniger Trainingsdaten für den zweiten neuronalen Prädiktor als für das vorbekannte LSTM-Modell erforderlich sein, und der zweite neuronale Prädiktor kann eine robustere Vorhersageleistung aufweisen.

In einer Ausgestaltung kann der Datensatz vergangener Betriebsdaten Strom und künstlich erzeugte Merkmale als Eingangsvariablen für das Training des zweiten Basismodells umfassen.

Durch die Wahl der Eingangsdaten kann ein weitestgehende Unabhängigkeit des zweiten neuronalen Prädiktors vom ersten neuronalen Prädiktor erreicht werden. Mit anderen Worten ist der erste neuronale Prädiktor im Wesentlichen entkoppelt von Degradationseinflüssen.

In einer Ausgestaltung kann die Verknüpfung der Ausgangswerte des ersten neuronalen Prädiktors und des zweiten neuronalen Prädiktors ein Addieren oder Subtrahieren des Ausgangswerts des ersten neuronalen Prädiktors zu oder von dem Ausgangswert des zweiten neuronalen Prädiktors umfassen.

Der Ausgangswert des zweiten neuronalen Prädiktors kann in dieser Ausgestaltung einen absoluten Verlust der Zellspannung aufgrund einer Degradation der Brennstoffzelle repräsentieren.

Alternativ kann die Verknüpfung der Ausgangswerte des ersten neuronalen Prädiktors und des zweiten neuronalen Prädiktors ein Multiplizieren des Ausgangswerts des ersten neuronalen Prädiktors mit dem Ausgangswert des zweiten neuronalen Prädiktors umfassen.

Der Ausgangswert des zweiten neuronalen Prädiktors kann in dieser Ausgestaltung einen relativen Verlust der Zellspannung aufgrund einer Degradation der Brennstoffzelle repräsentieren.

In einer Ausgestaltung kann das Verfahren ferner aufweisen: Trainieren des ersten neuronalen Prädiktors und/oder des zweiten neuronalen Prädiktors ausgehend von dem jeweiligen Basismodell basierend auf den Trainingsdaten durch eine Kreuzvalidierung. Die Kreuzvalidierung kann ein Trainieren einer Anzahl von neuronalen Netzen basierend auf jeweils einer Untermenge der Trainingsdaten umfassen. Die Untermenge kann durch ein vorbestimmtes Verhältnis von Trainings- zu Validierungsdaten bestimmt sein, sodass der erste neuronale Prädiktor und/oder der zweite neuronale Prädiktor für jede Untermenge ein trainiertes neuronales Netz umfassen kann. Das Verfahren kann ferner ein Ermitteln des Ausgangswertes des ersten Prädiktors und/oder des zweiten Prädiktors durch Bilden eines Mittelwerts der Ausgangswerte der jeweiligen trainierten neuronalen Netze umfassen.

Die Kreuzvalidierung minimiert das Risiko eines katastrophalen Vergessens der ersten und/oder zweiten Parameter während des Transferlernens des ersten neuronalen Prädiktors und/oder des zweiten neuronalen Prädiktors. Basierend auf den Trainingsdaten und dem jeweiligen Basismodell kann der erste neuronale Prädiktor bzw. der zweite neuronale Prädiktor in mehrfacher Ausführung trainiert werden. Dazu können jeweils unterschiedliche Abschnitte der Trainingsdaten zum Trainieren und Validieren eingesetzt werden. Das bedeutet, der erste neuronale Prädiktor und/oder der zweite neuronale Prädiktor umfassen jeweils eine Anzahl von neuronalen Netzen, wobei sich die Anzahl aus dem vorbestimmten Verhältnis von Trainings- zu Validierungsdaten in der Kreuzvalidierung bestimmen kann. Beispielsweise können sich für ein Verhältnis von 80:20 % 5 neuronale Netze ergeben, für ein Verhältnis von 75:25% 4 neuronale Netze, für ein Verhältnis von 90:10% bis zu 10 neuronale Netze.

In einer Ausgestaltung können die Trainingsdaten zwischen 15 und 1000 Datenpunkte, bevorzugt zwischen 35 und 200 Datenpunkte umfassen.

Diese Anzahl von Trainingsdaten ist im Vergleich zu vorbekannten Lernmodellen für die Vorhersage der Zellspannung einer Brennstoffzelle erheblich reduziert. Daher kann das Überwachungsmodell nach einem Aspekt der Erfindung erheblich effizienter bei gleichzeitig erhöhter Genauigkeit bereitgestellt werden als vorbekannte Modelle.

Nach einem weiteren Aspekt der Erfindung wird ein Verfahren zum Erkennen einer Anomalie in einem Betrieb einer elektrochemischen Anlage, insbesondere Brennstoffzelle, bereitgestellt. Das Verfahren umfasst ein Erfassen einer Zellspannung der elektrochemischen Anlage. Das Verfahren umfasst ein Vorhersagen der Zellspannung der elektrochemischen Anlage basierend auf einem Überwachungsmodell, das wie vorstehend beschrieben bereitgestellt ist. Das Verfahren umfasst Vergleichen der erfassten Zellspannung mit der vorhergesagten Zellspannung. Falls die erfasste Zellspannung für ein vorbestimmtes Zeitintervall außerhalb eines vorbestimmten Bereichs um die vorhergesagte Zellspannung ist, wird die Anomalie erkannt.

Der vorbestimmte Bereich um die vorhergesagte Zellspannung kann beispielsweise probabilistisch definiert werden. Da die Ausgabeschicht eine Gauß-Verteilung umfasst, kann der zulässige Bereich für Abweichungen von der vorhergesagten Zellspannung in Sigma-Intervallen definiert werden. 3 Sigma entsprechen beispielsweise 99,7% Wahrscheinlichkeit.

In einer Ausgestaltung kann das Vorhersagen und/oder das Vergleichen in Echtzeit ausgeführt werden. Dazu können vorteilhafterweise nur jeweils neue Datenpunkte aus den aufgezeichneten Logdaten der Brennstoffzelle an eine Auswerteeinheit übertragen werden.

In einer Ausgestaltung kann das Verfahren ferner ein Speichern der erfassten Zellspannung in Abhängigkeit der Betriebsbedingung umfassen. Das Verfahren kann ferner ein Aufbereiten der gespeicherten Zellspannung und Betriebsbedingung nach einem vorbestimmten Intervall als Trainingsdaten für den ersten neuronale Prädiktor und/oder den zweiten neuronale Prädiktor umfassen. Das Verfahren kann ferner ein Bereitstellen eines angepassten Überwachungsmodells, dessen erster neuronaler Prädiktor und/oder zweiter neuronaler Prädiktor basierend auf den neuen Trainingsdaten wie vorstehend beschrieben angepasst wird.

Der Einbezug von aufgezeichneten Betriebsdaten als Trainingsdaten in ein Anpassen des Überwachungsmodells ermöglich eine kontinuierliche Verbesserung des Überwachungsmodells. Dadurch kann insbesondere ein lebenslanges Lernen für den ersten neuronalen Prädiktor und/oder den zweiten neuronalen Prädiktor ermöglicht werden.

Nach einem weiteren Aspekt der Erfindung wird eine Vorrichtung zum Bereitstellen eines Überwachungsmodells zur Überwachung einer elektrochemischen Anlage, insbesondere Brennstoffzelle, bereitgestellt. Die Vorrichtung umfasst eine Speichereinrichtung und einen Prozessor. In der Speichereinrichtung sind erste Anweisungen zur Ausführung des ersten neuronalen Prädiktors und zweite Anweisungen zur Ausführung des zweiten neuronalen Prädiktors und jeweils ein Basismodell für den ersten neuronalen Prädiktor und/oder den zweiten neuronalen Prädiktor gespeichert. Der Prozessor ist eingerichtet, ein Verfahren wie vorstehend beschrieben auszuführen, wodurch die ersten Anweisungen

und die zweiten Anweisungen angepasst werden.

Die Vorrichtung ermöglicht die Ausführung der vorstehend beschriebenen Verfahren und erbt damit deren technische Vorteile.

Nach einem weiteren Aspekt der Erfindung wird ein System zum Erkennen einer Anomalie in einem Betrieb einer elektrochemischen Anlage, insbesondere Brennstoffzelle, bereitgestellt. Das System umfasst eine Datenerfassungseinrichtung, die eingerichtet ist, eine Zellspannung der elektrochemischen Anlage, vorzugsweise in Abhängigkeit der jeweiligen Betriebsbedingung, zu erfassen. Das System umfasst eine Auswerteeinrichtung, die eine Speichereinrichtung und einen Prozessor umfasst und eingerichtet ist, Daten von der Datenerfassungseinrichtung zu empfangen und/oder abzufragen. In der Speichereinrichtung sind Anweisungen zur Ausführung eines Überwachungsmodells, das wie vorstehend beschrieben bereitgestellt ist, gespeichert. Der Prozessor ist eingerichtet, ein Verfahren zum Erkennen einer Anomalie in einem Betrieb einer elektrochemischen Anlage, insbesondere Brennstoffzelle, wie vorstehend beschrieben, unter Verwendung der Anweisungen auszuführen.

In einer Ausgestaltung kann das System ferner eine zentrale Datenbankeinrichtung aufweisen. Die Datenerfassungseinrichtung kann ferner eingerichtet sein, die erfasste Zellspannung der elektrochemischen Anlage, vorzugsweise in Abhängigkeit der jeweiligen Betriebsbedingung, an die zentrale Datenbankeinrichtung zu übertragen, vorzugsweise in Echtzeit. Die Auswerteeinheit kann eingerichtet sein, Daten von der zentralen Datenbankeinrichtung zu empfangen und/oder abzufragen.

Nach einem weiteren Aspekt der Erfindung wird ein Computerprogramm mit Programmcode-Mitteln bereitgestellt, um ein vorstehend beschriebenes Verfahren durchzuführen, wenn das Programm auf einem Computer ausgeführt wird.

Nach einem weiteren Aspekt der Erfindung wird ein computerlesbarer Datenträger mit Programmcode bereitgestellt. Der Programmcode ist von einem Computer ausführbar, so dass der Computer ein vorstehend beschriebenes Verfahren ausführt.

## Kurzbeschreibung der Figuren

Im Folgenden werden die Erfindung oder weitere Ausführungsformen und Vorteile der Erfindung anhand von Zeichnungen näher erläutert, wobei die Zeichnungen nur Ausführungsformen der Erfindung beschreiben. Gleiche Bauteile sind in den Zeichnungen mit den gleichen Bezugszeichen versehen. Elemente, die mit gestrichelten Linien gezeichnet sind, werden als optionale Elemente betrachtet.

Die Zeichnungen sind nicht als maßstabsgetreu anzusehen, und einzelne Elemente der Zeichnungen können in übertrieben großer oder übertrieben vereinfachter Form dargestellt sein.

Fig. 1 zeigt einen schematischen Aufbau einer Brennstoffzelle.

Fig. 2 zeigt eine schematische Darstellung eines Überwachungsmodells nach einem Aspekt der Erfindung.

Fig. 3 zeigt eine schematische Darstellung eines ersten neuronalen Prädiktors nach einem Aspekt der Erfindung.

Fig. 4 zeigt eine schematische Darstellung für die Bereitstellung des ersten neuronalen Prädiktors und/oder des zweiten neuronalen Prädiktors nach einem Aspekt der Erfindung.

Fig. 5 zeigt ein Ablaufdiagramm für das Erkennen einer Anomalie in einer elektrochemischen Anlage nach einem Aspekt der Erfindung.

Fig. 6 zeigt eine Vorrichtung zum Bereitstellen des Überwachungsmodells aus Fig. 2.

Fig. 7 zeigt ein System zum Erkennen einer Anomalie in einem Betrieb einer elektrochemischen Anlage nach einem Aspekt der Erfindung.

## Ausführliche Beschreibung der Figuren

Fig. 1 zeigt einen schematischen Aufbau einer Brennstoffzelle. Brennstoffzellen sind galvanische Elemente, bei denen die chemische Energie direkt in elektrische Energie umgewandelt wird, wobei die jeweiligen Oxidations- und Reduktionsvorgänge räumlich voneinander in sogenannten Halbzellen ablaufen. Dadurch können die bei der Oxidation freiwerdenden Elektronen über einen äußeren Leiterkreis, in denen ein Verbraucher eingefügt ist, beispielsweise in einen Elektromotor geleitet und somit elektrische Arbeit verrichtet werden. Im Gegensatz zu Batterien werden bei Brennstoffzellen die Reaktanden Wasserstoff und Sauerstoff kontinuierlich zugeführt, so dass eine Stromerzeugung ohne Ladezeiten ermöglicht wird. Durch die direkte Energieumwandlung von chemischer in elektrischer Energie ergibt sich ein größerer Wirkungsgrad im Vergleich zu herkömmlichen Verbrennungskraftmaschinen.

Darüber hinaus werden zumindest in der Brennstoffzelle selbst keine mechanischen Bauteile bewegt, wodurch eine geräuscharme und mechanisch verschleißfreie Arbeitsweise möglich wird. Brennstoffzellen arbeiten ähnlich wie Batterien und haben jedoch im Vergleich zu batteriebetriebenen Vorrichtungen, beispielsweise bei Fahrzeugen den Vorteil, dass keine langen Ladezeiten erforderlich sind und Betankung mit den Reaktanzen ähnlich wie bei Verbrennungsmotoren möglich ist.

Ein Vertreter der Brennstoffzellen, die hier nur beispielsweise genannt ist, ist die Polymerelektrolytmembranbrennstoffzelle (PEMFC). Diese gehört zu den Niedertemperaturbrennstoffzellen, wobei zwischen Niedertemperatur (NT)-PEMFC mit Betriebstemperatur kleiner gleich 90° C und der Hochtemperatur (HT)-PEMFC mit Betriebstemperaturen größer 100° C unterschieden wird.

Bei Niedrigtemperaturbrennstoffzellen wird standardmäßig eine protonenleitende Membran, beispielsweise aus perfluoriertem Sulfonsäure-Polymer verwendet, wobei bei HT-PEMFC eine Membran aus Polybenzimidazol (PBI), die mit Phosphorsäure als Elektrolyten versetzt ist, verwendet wird. In beiden Fällen wird das Oxonium ($H_3O^+$)-Ion als Ladungsträger über die Membran transportiert. Als Brenngas wird anodenseitig reiner Wasserstoff oder Reformatgas eingesetzt und als Oxidationsmittel wird kathodenseitig Luft oder auch reiner Sauerstoff verwendet. Die zugrundeliegenden Zellreaktionen bei einer PEMFC sind folgende:

| | |
|---|---|
| Anode: | $H_2 + 2\ H_2O \Leftrightarrow 2\ H_3O^+ + 2e^-$ |
| Kathode: | $½\ O_2 + 2\ H_3O^+ + 2e^- \Leftrightarrow 3\ H_2O$ |
| Gesamtreaktion: | $H_2 + 1/2\ O_2 \Leftrightarrow H_2O$ |

Die Niedrigtemperatur PEMFC erreicht im Vergleich zu anderen Brennstoffzellarten die größte Leistungsdichte mit 0,3 bis über 1 $W/cm^2$. Außerdem zeichnet sie sich durch eine niedrige Betriebstemperatur und rasche Anfahrts- und Abschaltfähigkeit und auch einen hohen Wirkungsgrad im Teilungsbereich aus, wodurch sie sowohl für stationäre als auch portable oder automobil Systeme geeignet ist. Nachteilig sind die Kosten für die Edelmetalle des Katalysators (Platin, Ruthenium) und dessen Empfindlichkeit gegenüber Kohlenmonoxid und Schwefelverbindungen, wodurch eine hohe Reinheit der verwendeten Gase erforderlich ist. Weiter ist bei der Verwendung von NT-PEMFC ein Befeuchten der Reaktanden insbesondere bei höheren Betriebstemperaturen erforderlich, um ein Austrocknen der Membran zu verhindern. Die PEMFC-Einzelzelle besteht aus zwei Halbzellen (Anode/Kathode), wobei die Halbzellen durch eine Polymerelektrolytmembran voneinander getrennt sind. Diese Membran ist gasdicht und elektrisch isolierend. Auf der Anodenseite wird das Oxonium im Folgenden vereinfacht als Proton bezeichnet, erzeugt, wobei die Protonen über die Membran zur Kathode geleitet werden. Um einen möglichst guten Protonentransport über die Membran zu gewährleisten, muss die Membran befeuchtet sein. Je besser die Membran befeuchtet ist, desto geringer ist der Membranwiderstand. Angrenzend zur Membran befindet sich die Kathodenelektrode und Anodenelektrode in Form der Katalysatorschicht, für die meist Platin oder Platinlegierungen verwendet werden. Die Membran und die Elektrode werden meist industriell als Komponenteneinheit gefertigt und durch eine Gasdiffusionslage stabilisiert. Die Aufgabe der Gasdiffusionslage (GDL) besteht im Wesentlichen in der homogenen Verteilung der gasförmigen Reaktanden zur Katalysatorschicht und dem Abtransport des kathodenseitig erzeugten Produktwassers. Weiterhin verteilt die GDL die Verspannkraft die über die Bipolarplatten eingeleitet wird flächig auf die Membran und agiert so zusätzlich als mechanische Feder in der Brennstoffzelle. Angrenzend an die GDL befindet sich anoden- als auch kathodenseitig eine Strömungsverteilerplatte mit Strömungskanälen, die auch als Flowfield bezeichnet wird. Über das Flowfield soll eine möglichst homogene Verteilung der Reaktanden über die gesamte Aktivfläche der PEMFEC erreicht werden. Bei einer Einzelzelle erfolgt angrenzend zur Strömungsverteilerplatte die Stromabnehmerplatte, um die anodenseitig erzeugten Elektroden über den erzeugten Leiterkreis und den elektrischen Verbraucher zur Kathode zu transportieren. Um jedoch eine möglichst hohe Gesamtleistung mit höheren Gesamtspannungen zu erzielen, werden die jeweiligen Einzelzellen zu einem Brennstoffstapel (Brennstoffzellenstack) aufgebaut und in Serie geschaltet. Da bei einem Stack die Strömungsverteilerplatten der Anode und der Kathode von benachbarten Einzelzellen in direktem Kontakt zueinander stehen, werden die beiden Platten zu sogenannten Bipolarplatten zusammengefasst, bei der sich auf der einen das anodenseitige und auf der anderen Seite das kathodenseitige Flowfield befindet. Die Bipolarplatte besteht ebenfalls aus einem elektrisch leitenden Material, um die Elektroden von der Anode zur Kathode der nächsten Zelle zu transportieren.

Die Funktionsweise einer PEMFEC ist in Figur 1 dargestellt. Die Brennstoffzelle gemäß Fig. 1 setzt sich aus einer Kathode und einer Anode zusammen, zwischen denen eine Membran angeordnet ist. Die Polymerelektrolytmembran hat die Aufgabe, die anodenseitig produzierten Protonen zur Kathode zu transportieren. Somit muss die Membran eine sehr hohe Protonenleitfähigkeit aufweisen. Die Membran zwischen der Anode und der Kathode dient der Separierung der beiden Halbzellen, indem sie zum einen eine sehr niedrige Elektronenleitfähigkeit aufweist und zum anderen praktisch undurchlässig für Wasserstoff und Sauerstoff ist. Die Membran ist in der Lage, flüssiges Wasser einzulagern, wodurch es zur Quellung der Membran kommt und die Membran ihr Volumen um bis zu 22% erhöhen kann. Durch die Quellung der Membran entstehen mit Wasser gefüllte Cluster, die über Kanäle von ca. 3 nm miteinander verbunden sind. Letztlich wird durch die Quellung der Membran die energetische Barriere für die Protonenwanderung und damit der Membranwiderstand abgesenkt. Der Durchmesser der mit Wasser gefüllten Cluster ist stark vom Wassergehalt der Membran abhängig,

wobei es bei Abnahme des Wassergehalts auch zu einer Abnahme der Durchlässigkeit des Clusters kommt, wodurch die Protonen einer größeren elektrostatischen Wechselwirkung ausgesetzt sind, und der Membranwiderstand steigt, so dass die Leistung der Brennstoffzelle verringert wird. Daher muss die Membran stets befeuchtet sein und die Temperatur muss überwacht werden. Um eine ausweichende Membranbefeuchtung sicher zu stellen, müssen die Reaktionsgase bei Betriebstemperaturen oberhalb von ca. 50° C extern befeuchtet werden.

Aus dem komplexen Aufbau der Brennstoffzelle gemäß Fig. 1 ergeben sich viele Degradationsmöglichkeiten, die erheblichen Einfluss auf die Leistung der Brennstoffzelle als auch auf die Lebensdauer der Brennstoffzelle haben.

Um derartige Veränderungen bzw. Verschlechterungen einzelner Bauteile/Baugruppen der Brennstoffzelle zu erkennen, wird erfindungsgemäß ein Verfahren und eine Vorrichtung zur Überwachung der Brennstoffzelle angegeben.

Fig. 2 zeigt eine schematische Darstellung Überwachungsmodells 30 nach einem Aspekt der Erfindung. Das Überwachungsmodell 30 kann ein digitaler Zwilling für die Brennstoffzellenüberwachung sein, der einen ersten neuronalen Prädiktor 10, etwa als stationäre Brennstoffzellenmodell, und einen zweiten neuronalen Prädiktor 20, etwa als Degradationsmodell, umfasst. Eine Verknüpfung 15 der stationären Vorhersage und der Degradationsvorhersage ergibt eine Vorhersage für die degradierte Zellspannung.

Der erste neuronale Prädiktor 10 für eine stationäre Brennstoffzelle kann ein vollständig vernetztes neuronales Netz 10_i zur Vorhersage der Spannung einer stationären Zelle auf der Grundlage der Betriebsbedingungen umfassen. Zu diesen Betriebsbedingungen gehören Druck, Taupunkttemperatur und Stöchiometrie der Reaktanten, Zelleinlasstemperatur und Zellauslasstemperatur, Stromdichte und einige künstliche Merkmale. Das neuronale Netz 10_i und seine Gaußsche Ausgangsschicht 14 können den Erwartungswert und die Varianz einer Gaußschen Verteilung der resultierenden Zellspannung ermitteln. Als Ergebnis liefert der erste neuronale Prädiktor 10 nicht nur eine Vorhersage für die Zellspannung (Erwartungswert), sondern auch einen Zuverlässigkeitsgrad (Varianz) für die Vorhersage.

Da für das Training neuronaler Netze derartiger Komplexität in der Regel große Datensätze erforderlich sind, kann der erste neuronale Prädiktor 10 ausgehend von einem ersten Basismodell 11 trainiert werden. Eine genauere Beschreibung dazu ist mit Bezug zur Fig. 4 angegeben. Das vortrainierte erste Basismodell 11 kann mittels eines kleinen realer Datensatzes mit weniger als 100 Datenpunkten an die reale Brennstoffzelle angepasst werden.

Der zweite neuronale Prädiktor 20 kann die Vorhersagen des ersten neuronalen Prädiktors 10 korrigieren, indem es zeitabhängige Brennstoffzelleneffekte wie reversible und irreversible Degradation berücksichtigt. In Kombination mit den Vorhersagen des stationären Modells führt die Degradationsvorhersage zu einer genauen Vorhersage der degradierten Zellspannung auf der Grundlage aktueller und früherer Betriebsbedingungen, einschließlich früherer Ereignisse.

Der zweite neuronale Prädiktor 20 kann ein zweites neuronales Netz 20_i umfassen, das eine Gedächtnisfunktion bzw. mindestens eine Gedächtniszelle umfasst. Dadurch kann das zweite neuronale Netz 20_i Informationen über lange Zeiträume hinweg speichern. Die Gedächtnisfunktion ermöglicht somit den Kontext früherer Betriebsvorkommnisse einer Brennstoffzelle in einer Sequenz für die Verarbeitung aktueller Betriebsdaten einzubeziehen. Auch für das Training der zweiten neuronalen Prädiktors 20 sind in der Regel große Datensätze erforderlich. Nach einem Aspekt der Erfindung, jedoch, kann der zweite neuronale Prädiktor 20 ausgehend von einem zweiten Basismodell 21 trainiert werden, wie mit Bezug zu Fig. 4 näher erläutert. Das vortrainierte zweite Basismodell 21 kann ebenfalls mittels eines kleinen realer Datensatzes an die reale Brennstoffzelle angepasst werden.

Somit kann das Überwachungsmodell 30 als solches mittels Trainingsdaten 50, die eine kleine Anzahl an Datenpunkten umfassen, an zu überwachende Brennstoffzellen angepasst werden.

Das Überwachungsmodell 30 kann eingerichtet sein, als idealisierter digitaler Zwilling eine Zellspannung der Brennstoffzelle im Betrieb vorherzusagen, der ohne unvorhergesehene Einflüsse ist. Durch Vergleich der realen, momentanen oder aktuellen Zellspannungen einer zu überwachenden Brennstoffzelle kann aus einer Abweichung von der vorhergesagten Zellspannung auf unvorhergesehene Umgebungseinflüsse der Brennstoffzelle geschlossen werden. Beispielsweise können störende Gase, wie etwa Ammoniak, die Zellspannung einer Brennstoffzelle erheblich beeinträchtigen. Derartige Beeinträchtigungen können durch Vergleich mit dem digitalen Zwilling als Anomalie erkannt werden. Ein Fahrzeug, das zumindest teilweise durch eine mittels des Überwachungsmodells 30 überwachten Brennstoffzelle angetrieben ist, und sich vorübergehend durch Ammoniak-haltige Umgebungsluft bewegt, kann entsprechend auf eine derartige Anomalieerkennung reagieren. Z.B., kann das Fahrzeug als Folge der Anomalieerkennung seine Energiezufuhr aus der Brennstoffzelle vorübergehend drosseln, um eine Degradation der Brennstoffzelle abzuschwächen.

Fig. 3 zeigt eine schematische Darstellung eines ersten neuronalen Prädiktors nach einem Aspekt der Erfindung.

Der erste neuronale Prädiktor 10 kann ein oder mehrere vollvernetzte neuronale Netze 10_1, ..., 10_i umfassen. Das erste Basismodell 11 kann ebenfalls ein vollvernetztes neuronales Netz umfassen, das dieselbe Architektur aufweist, wie die neuronalen Netze 10_1, ..., 10_i des ersten neuronalen Prädiktors 10. Die Architektur des neuronalen Netzes, ist wie in Fig. 3 gezeigt, maßgeblich durch die Anreihung von verborgenen Schichten 13 hinter eine Eingangsschicht 12 und vor eine Ausgangsschicht 14 bestimmt. Jede Schicht weist eine vorbestimmte Anzahl von Knoten auf, auch als Neuronen

bezeichnet. Die Neuronen der Eingangsschicht 12 dienen dem Zuordnen der Eingangsvariablen, auch als Eingangsvektoren bzw. Eingangsmerkmale bezeichnet. Im Ausführungsbeispiel der Fig. 3 sind als Eingangsmerkmale beispielhaft Strom(dichte), Stöchiometrie, Druck, Temperatur / Tau Punkt sowie weitere künstliche Merkmale bzw. Variablen aufgelistet. Jeder Knoten der Eingangsschicht 12 repräsentiert jeweils den entsprechenden Wert einer Eingangsvariablen pro Datenpunkt. Die Knoten einer jeden verborgenen Schicht 13 sind jeweils mit allen Knoten der vorherigen und der nachfolgenden Schicht vernetzt. Diese Vernetzung ist durch Kanten in Fig. 3 dargestellt, wobei jeder Kante ein Gewicht als interner Parameter des ersten neuronalen Prädiktors 10 zugeordnet ist. Zusätzlich ist jeder Schicht 12, 13, 14 ein Bias-Term zugeordnet. Die physische Eingabe wird in die Eingabeschicht 12 eingespeist, wo jedes Neuron in der ersten versteckten bzw. verborgenen Schicht die von der vorherigen Schicht erhaltenen Informationen verarbeitet, indem es eine gewichtete Summe seiner Eingaben berechnet und einen Vorspannungsterm (Bias-Term) hinzufügt. Die Summe wird dann durch eine Aktivierungsfunktion transformiert. Die Informationen werden dann auf die gleiche Weise durch die verbleibenden versteckten Schichten weitergeleitet, bis sie die letzte Schicht erreichen, die so genannte Ausgabeschicht 14.

Der Prozess des Trainings eines neuronalen Netzes, etwa des ersten Basismodells 11, bezieht sich auf die Optimierung der Gewichte und Bias-Terme des Netzes in Bezug auf eine vordefinierte Verlustfunktion. Zu Beginn des Trainings eines neuen Netzes werden die Gewichte und Bias-Terme des neuronalen Netzes nach dem Zufallsprinzip ausgewählt. Die Parameter können iterativ, etwa durch einen Adam-Optimierer, einen Backpropagation-Algorithmus, aktualisiert werden. Der Backpropagations-Algorithmus berechnet den Gradienten der Verlustfunktion in Bezug auf die Gewichte und Bias-Terme des Netzes. Auf der Grundlage der Gaußschen Ausgangsschicht 14 des Modells kann die Gaußsche negative Log-Likelihood als Verlustfunktion verwendet werden. Während des Trainings maximiert diese Funktion die Wahrscheinlichkeit, dass die Ziele aus einer Gauß-Verteilung mit dem vorhergesagten Erwartungswert und der vorhergesagten Varianz gezogen werden.

Um die Genauigkeit nach dem Training des Modells zu testen, können 20 % jedes Datensatzes als Testdatensatz aufbewahrt und nur zur Bewertung nach dem Training verwendet werden. Die verbleibenden 80 % jedes Datensatzes können wiederum in einen Trainings- und einen Validierungsdatensatz im Verhältnis von 80 % zu 20 % aufgeteilt. Der Trainingsdatensatz kann während des Trainings zur Berechnung des Verlusts und zur Aktualisierung der Netzwerkparameter verwendet werden, während der Validierungsdatensatz zur Überwachung des Trainingsfortschritts dient. Das Training wird beispielsweise abgebrochen, wenn der Fehler in der Validierungsmenge wieder ansteigt.

Neuronale Netze weisen mehrere Hyperparameter auf, sowohl für die Struktur bzw. Architektur wie die Anzahl der Neuronen und Schichten, als auch für das Training, wie die Lernrate, die Stapelgröße und die Anzahl der Trainingsepochen. Diese Parameter haben einen starken Einfluss auf die Genauigkeit des Modells und die Konvergenz des Trainings. Um den optimalen Satz von Hyperparametern zu bestimmen, kann eine Hyperparameter-Optimierung, beispielsweise mit Hilfe des Optimierers PGPE (Parameter-exploring Policy Gradients), durchgeführt werden. PGPE, ein stochastischer Optimierungsalgorithmus, gehört zur Familie der Black-Box-Optimierer, die besonders geeignet für eine Hyperparameter-Optimierung neuronaler Netze sind. Die Hyperparameter der neuronalen Netze können unter Verwendung des aktuellen einheitlichen Datensatzes ohne zusätzliche Merkmale optimiert werden. Im Einzelnen können die Netzarchitektur, d.h. die Anzahl der Schichten und die Anzahl der Neuronen pro Schicht, sowie die Lernparameter Stapelgröße, Lernrate und Gewichtsabnahme optimiert werden. Die Koeffizienten des Adam-Optimierers können hingegen konstant gelassen werden.

Nach einem Aspekt der Erfindung sind jedoch lediglich das erste Basismodell 11 und das zweite Basismodell 21 jeweils klassisch, d.h., basierend auf einer zufälligen Initialisierung ihrer internen ersten bzw. zweiten Parameter zu trainieren. Für diese Trainings werden vorteilhafterweise Simulationsdaten 65 eingesetzt, insbesondere für das Training des ersten Basismodells 11.

Das Training des ersten neuronalen Prädiktors 10 und des zweiten neuronalen Prädiktors 20 hingegen kann ausgehend von dem jeweiligen Basismodell 11, 21 erheblich vereinfacht werden, wie nachfolgend mit Bezug zur Fig. 4 beschrieben.

Fig. 4 zeigt eine schematische Darstellung für die Bereitstellung des ersten neuronalen Prädiktors und/oder des zweiten neuronalen Prädiktors nach einem Aspekt der Erfindung.

Die Darstellung der Fig. 4 weist eine horizontale Richtung bzw. Zeilenrichtung und eine vertikale Richtung bzw. Spaltenrichtung. In der Zeilenrichtung ist die Entwicklung des Überwachungsmodells in seinen einzelnen Schritten, ausgehend von einer physikbasierten Simulation 60 und/oder Datensätzen 70, 75 aus Betriebshistorien, jeweils für den ersten neuronalen Prädiktor 10 und/oder den zweiten neuronalen Prädiktor 20 dargestellt.

In einem ersten horizontalen Schritt werden aus der Simulation 60 bzw. den Datensätzen 70, 75 Trainingsdaten 65 generiert. Bei den Trainingsdaten 65 handelt es sich um einen vergleichsweise großen Trainingsdatensatz mit mehreren tausend Datenpunkten, vorzugsweise mehr als 5000 Datenpunkte, mehr bevorzugt mehr als 10000 Datenpunkte.

Basierend auf den Trainingsdaten 65 kann sowohl für den ersten neuronalen Prädiktor 10 als auch für den zweiten neuronalen Prädiktor 20 der erste vertikale Schritt in Fig. 4 ausgeführt werden: Das Trainieren S0 eines jeweiligen

Basismodells 11, 21.

Ausgehend von dem ersten Basismodell 11 bzw. dem zweiten Basismodell 21 kann in einem weiteren horizontalen Schritt der erste neuronale Prädiktor 10 bzw. der zweite neuronale Prädiktor 20 mittels Transferlernen trainiert werden (S1, S2). Hierzu können neue Trainingsdaten 50 der zu überwachenden Brennstoffzelle erfasst werden. Der Trainingsdatensatz 50 für das Transferlernen ist vergleichsweise klein und umfasst eine Anzahl von Datenpunkten, die in der Größenordnung von etwa 50 liegt.

Die Technik des Transferlernens ermöglicht es, ein zuvor trainiertes Basismodell 11, 21 auf ein neues, leicht verändertes Problem anzuwenden, indem das Modell 11, 21 erneut mit neuen Trainingsdaten 50 trainiert wird. Da das Training jedoch nicht mit zufällig initialisierten Netzwerkparametern beginnt, sondern mit den optimierten ersten bzw. zweiten Parametern aus dem ursprünglichen Training, werden für das Transferlernen viel weniger neue Trainingsdaten 50 benötigt. Eine der größten Herausforderungen beim Transferlernen ist jedoch das katastrophale Vergessen, bei dem das zuvor gelernte Wissen des Basismodells 11, 21 vergessen oder durch neues Wissen ersetzt werden kann. Um diesem Effekt entgegenzuwirken, können bspw. einige Schichten des Basismodells 11, 21 für den Transferlernprozess deaktiviert werden, sodass die ursprünglichen Gewichte dieser deaktivierten Schichten beibehalten werden. So können während des Trainings nur die Gewichte in den nicht deaktivierten Schichten aktualisiert werden. Auf diese Weise kann sichergestellt werden, dass das ursprüngliche Wissen nicht vollständig in Vergessenheit gerät, das Modell 11, 21 aber dennoch in der Lage ist, neue Zusammenhänge aus den neuen Trainingsdaten 50 zu lernen. Während des Trainierens S1, S2 des ersten neuronalen Prädiktors 10 und/oder des zweiten neuronalen Prädiktors kann die Anzahl der zu deaktivierenden Schichten als Hyperparameter optimiert werden.

Für das Transfer-Lernen können wiederum 20 % jedes Datensatzes zum Testen verwendet werden. Die verbleibenden 80 % jedes Datensatzes können in zwei Teilmengen aufgeteilt werden, wobei 80 % dem Trainingssatz und 20 % dem Validierungssatz zugewiesen werden können. Für jede der verschiedenen Datensatzgrößen kann eine Hyperparameter-Optimierung durchgeführt, um die optimale Anzahl der deaktivierten Schichten zu ermitteln und die trainingsbezogenen Hyperparameter zu optimieren. Da die Genauigkeit des resultierenden Modells 10_1, ..., 10_i, 20_1, ..., 20_i stark von der Aufteilung in Trainings- und Validierungsdatensatz abhängt, insbesondere bei kleinen Datensätzen mit nur wenigen Datenpunkte im Validierungsdatensatz, kann eine mehrfache Kreuzvalidierung zur Optimierung der Hyperparameter verwendet werden. Die jeweiligen Modelle 10_1, ... 10_i, 20_1, ..., 20_i aus der Kreuzvalidierung können dann zu dem ersten neuronalen Prädiktor 10 bzw. dem zweiten neuronalen Prädiktor 20 kombiniert werden. Der erste neuronale Prädiktor 10 und/oder der zweite neuronale Prädiktor 20 kann jeweils ein Ensemble-Modell sein.

Vorläufige Tests der Erfinder haben ergeben, dass als Mindestbedarf an Daten für das Transfer-lernen 15 bis 35, insbesondere 20 bis 30, Datenpunkte erforderlich sind. Ab etwa 80-100 Datenpunkten scheinen zusätzliche Datenpunkte nicht mehr zu einer weiteren signifikanten Verbesserung beizutragen.

Der erzeugte erste neuronale Prädiktor 10 und der erzeugte zweite neuronale Prädiktor 20 können in dem nächsten horizontalen Schritt der Fig. 4 zu dem Überwachungsmodell 30 verknüpft werden, das zur Überwachung der Brennstoffzelle bereitgestellt werden kann.

In dem letzten vertikalen Schritt ist gestrichelt gekennzeichnet, dass das Überwachungsmodell 30 basierend auf neuen Betriebsdaten 55 die erwartete Zellspannung der Brennstoffzelle präzise vorhersagen kann (S4). Dieser Schritt ist weiter mit Bezug zur Fig. 5 erläutert.

Fig. 5 zeigt ein Ablaufdiagramm für das Erkennen einer Anomalie in einer elektrochemischen Anlage nach einem Aspekt der Erfindung.

Das Ablaufdiagramm der Fig. 5 skizziert ein Verfahren zum Erkennen einer Anomalie in einem Betrieb einer elektrochemischen Anlage, insbesondere Brennstoffzelle.

In einem ersten Schritt, S3, umfasst das Verfahren ein Erfassen einer Zellspannung der elektrochemischen Anlage, also einer aktuell gemessenen Zellspannung.

In einem zweiten Schritt, S4, umfasst das Verfahren ein Vorhersagen der Zellspannung der elektrochemischen Anlage basierend auf dem vorstehend beschriebenen Überwachungsmodell 30. Hierzu kannjeweils ein aktuell erfasster Datensatz physikalischer Eingangsvariablen in den ersten neuronalen Prädiktor 10 und den zweiten neuronalen Prädiktor 20 eingegeben werden, wobei sich die Eingangsvariablen wie vorstehend beschrieben erheblich unterscheiden. Beispielsweise kann der Strom als einzige gemeinsame Eingangsvariable fungieren. Jedes der neuronalen Netze 10_1, ..., 10_i, 20_1, ..., 20_i des ersten neuronalen Prädiktors 10 und des zweiten neuronalen Prädiktors 20 können einen jeweiligen Vorhersagewert ausgeben. Durch Mittelwertbildung, beispielsweise als Median, kann für den ersten neuronalen Prädiktor 10 ein stationärer Vorhersagewert für die Zellspannung ermittelt werden. Gleichermaßen kann für den zweiten neuronalen Prädiktor 20 ein Vorhersagewert für den Alterungseinfluss auf die Zellspannung, etwa als Degradationskorrektur, ermittelt werden. Zur Vorhersage der erwartbaren Zellspannung für die überwachte Brennstoffzelle werden der Ausgabewert des ersten neuronalen Prädiktors 10 mit dem Ausgabewert des zweiten neuronalen Prädiktors 20 verknüpft, beispielsweise durch Addieren oder Subtrahieren.

Beispielsweise kann der Ausgangswert des zweiten neuronalen Prädiktors 20 einen absoluten Spannungsverlust der Brennstoffzelle aufgrund einer Degradation repräsentieren. Der erste neuronale Prädiktor 10 kann beispielsweise eine Zellspannung von 600 mV vorhersagen, die durch den zweiten neuronale Prädiktor 20 um beispielsweise -17 mV nach unten korrigiert werden kann.

Die finale Vorhersage der erwarteten Zellspannung von in diesem Beispiel 583 mV kann sich als Addition der Vorhersagewerte der beiden neuronalen Prädiktoren 10, 20 ergeben.

In einem dritten Schritt, S5, umfasst das Verfahren ein Vergleichen der erfassten Zellspannung mit der vorhergesagten Zellspannung. Falls die erfasste Zellspannung für ein vorbestimmtes Zeitintervall außerhalb eines vorbestimmten Bereichs um die vorhergesagte Zellspannung ist, umfasst das Verfahren in einem vierten Schritt, S6, ein Erkennen der Anomalie. Der vorbestimmte Bereich kann beispielsweise probabilistisch definiert werden. Da die Ausgabeschicht eine Gauß-Verteilung umfasst, kann der zulässige Bereich für Abweichungen von der vorhergesagten Zellspannung in Sigma-Intervallen definiert werden. 3 Sigma entsprechen beispielsweise 99,7% Wahrscheinlichkeit.

Fig. 6 zeigt eine Vorrichtung 1 zum Bereitstellen des Überwachungsmodells 30 aus Fig. 2.

Die Vorrichtung 1 nach Fig. 6 umfasst eine Speichereinrichtung 2 und einen Prozessor 3. In der Speichereinrichtung 2 sind erste Anweisungen zur Ausführung des ersten neuronalen Prädiktors 10 und zweite Anweisungen zur Ausführung des zweiten neuronalen Prädiktors 20 und jeweils ein Basismodell 11, 21 für den ersten neuronalen Prädiktor 10 und/oder den zweiten neuronalen Prädiktor 20 gespeichert. Die Anweisungen können Programmcode und interne Parameter des ersten neuronale Prädiktors 10 und/oder des zweiten neuronalen Prädiktor 20 umfassen, die benötigt werden, den jeweiligen Prädiktor 10, 20 auszuführen. Die Anweisungen können demnach Gewichte, Bias, Aktivierungsfunktionen sowie etwaige Routinen zur Aufbereitung bzw. Normalisierung der mehrere physikalischen Eingangsvariablen und/oder davon abgeleiteten Merkmalen umfassen. Insbesondere können die ersten Anweisungen die ersten Parameter des ersten Basismodells 10 umfassen und die zweiten Anweisungen die zweiten Parameter des zweiten Basismodells 20.

Der Prozessor 3 ist eingerichtet, ein Verfahren wie vorstehend beschrieben auszuführen, wodurch die ersten Anweisungen und die zweiten Anweisungen angepasst werden.

Die Vorrichtung 1 kann ferner eine mit gestrichelten Elementen angedeutete Datenschnittstelle aufweisen, um Trainingsdaten 50 und/oder reale Betriebsdaten 55 zu empfangen. Der Prozessor 3 kann eingerichtet sein, mit der Datenschnittstelle und/oder mit der Speichereinrichtung 2 zu kommunizieren.

Fig. 7 zeigt ein System 100 zum Erkennen einer Anomalie in einem Betrieb einer elektrochemischen Anlage nach einem Aspekt der Erfindung.

Das System nach Fig. 7 umfasst eine Datenerfassungseinrichtung 4, die eingerichtet ist, eine Zellspannung der elektrochemischen Anlage, vorzugsweise in Abhängigkeit der jeweiligen Betriebsbedingung, zu erfassen. Die elektrochemische Anlage ist bevorzugt eine Brennstoffzelle, insbesondere PEM-Brennstoffzelle.

Das System 100 umfasst zudem eine Auswerteeinrichtung 1’, die eine Speichereinrichtung 2’ und einen Prozessor 3’ umfasst. Die Auswerteeinrichtung 1’ ist eingerichtet, Daten von der Datenerfassungseinrichtung 4 zu empfangen und/oder abzufragen. Hierzu kann die Auswerteeinrichtung 1’ eine mit gestrichelten Elementen angedeutete Datenschnittstelle aufweisen. Der Prozessor 3’ kann eingerichtet sein, mit der Datenschnittstelle und/oder mit der Speichereinrichtung 2’ zu kommunizieren. In der Speichereinrichtung 2’ sind Anweisungen zur Ausführung eines Überwachungsmodells 30, das wie vorstehend beschrieben bereitgestellt ist, gespeichert. Der Prozessor 3’ ist eingerichtet, ein Verfahren zum Erkennen einer Anomalie in einem Betrieb einer elektrochemischen Anlage, insbesondere Brennstoffzelle, wie vorstehend beschrieben, unter Verwendung der Anweisungen auszuführen. Die Auswerteeinrichtung 1’ kann die Vorrichtung 1 sein bzw. umfassen.

## Bezugszeichenliste

| | |
|---|---|
| 1, 1’ | Vorrichtung |
| 2, 2’ | Speichereinrichtung |
| 3, 3’ | Prozessor |
| 4 | Datenerfassungseinrichtung |
| 10 | erster neuronaler Prädiktor |
| 10_1, ..., 10_i | neuronale Netze des ersten neuronalen Prädiktors 10 |
| 11 | erstes Basismodell |
| 12 | Eingangsschicht |
| 13 | versteckte Schichten |
| 14 | Ausgangsschicht |
| 20 | zweiter neuronaler Prädiktor |
| 10_1, ..., 10_i | neuronale Netze des zweiten neuronalen Prädiktors 10 |
| 21 | zweites Basismodell |

| | |
|---|---|
| 30 | Überwachungsmodell |
| 50 | Trainingsdaten für das Transferlernen |
| 55 | Momentane Betriebsdaten |
| 60 | Simulation |
| 65 | Trainingsdaten für das erste Basismodell 11 bzw. das zweite Basismodell 21 |
| 70 | vergangenen Betriebsdaten für den ersten neuronalen Prädiktor 10 |
| 75 | vergangene Betriebsdaten für den ersten neuronalen Prädiktor 20 |
| 100 | System |

## Patentansprüche

1. Verfahren zum Bereitstellen eines Überwachungsmodells (30) zur Überwachung einer elektrochemischen Anlage insbesondere einer Brennstoffzelle, das Verfahren umfassend:

    Erfassen von Betriebsdaten der elektrochemischen Anlage als Trainingsdaten (50);
    Trainieren (S1) eines ersten neuronalen Prädiktors (10) basierend auf den Trainingsdaten (50) zum Vorhersagen einer Zellspannung, wobei der erste neuronale Prädiktor (10) einen stationären Betrieb der elektrochemischen Anlage repräsentiert;
    Trainieren (S2) eines zweiten neuronalen Prädiktors (20) basierend auf den Trainingsdaten (50) zum Vorhersagen eines Alterungseinflusses auf die Zellspannung der elektrochemischen Anlage,
    wobei der erste neuronale Prädiktor (10) und/oder der zweite neuronale Prädiktor (20) ausgehend von einem jeweiligen Basismodell (11, 21) trainiert werden, wobei der erste neuronale Prädiktor (10) und der zweite neuronale Prädiktor (20) jeweils eingerichtet sind, einen Ausgangswert zu erzeugen; und
    Bereitstellen des Überwachungsmodells (30), das den ersten neuronalen Prädiktor (10), den zweiten neuronalen Prädiktor (20) und eine Verknüpfung (15) derer Ausgangswerte umfasst.

2. Verfahren nach Anspruch 1, wobei das Verfahren ferner umfasst:
    Trainieren (S1) des ersten neuronalen Prädiktors (10) ausgehend von einem ersten Basismodell (11), das erste Parameter umfasst, wobei die ersten Parameter basierend auf Realdaten (70) und/oder einer Simulation (60) der elektrochemischen Anlage ermittelt sind.

3. Verfahren nach Anspruch 2, wobei die elektrochemische Anlage eine Brennstoffzelle ist und mehrere Zellsegmente umfasst, wobei die Simulation (60) eingerichtet ist, für jedes Zellsegment eine Spannung basierend auf mehreren physikalischen Eingangsvariablen zu ermitteln, und eine Zellspannung der Brennstoffzelle basierend auf den Spannungen der Zellsegmente zu ermitteln.

4. Verfahren nach Anspruch 3, wobei die Simulation (60) eingerichtet ist, durch Abtasten von Werten für die mehreren physikalischen Eingangsvariablen Trainingsdaten (65) für eine Vielzahl von Betriebsbedingungen zum Ermitteln (S0) der ersten Parameter des ersten Basismodells (11) zu erzeugen, vorzugsweise durch einen gleichmäßig abgetasteten Strom oder durch eine gleichmäßige Verteilung der ermittelten Zellspannung.

5. Verfahren nach Anspruch 4, wobei die Trainingsdaten (65) mehrere Merkmalsvektoren umfassen, die jeweils einen Datenpunkt repräsentieren und eine vorbestimmte Anzahl physikalischer Eingangsmerkmale und ein dazu korrespondierender Spannungswert umfassen, wobei das Verfahren ferner umfasst: Erzeugen der physikalischen Eingangsmerkale durch Transformieren der physikalischen Eingangsvariablen der Simulation (60).

6. Verfahren nach einem der vorhergehenden Ansprüche, wobei das Verfahren ferner umfasst:
    Trainieren (S2) des zweiten neuronalen Prädiktors (20) ausgehend von einem zweiten Basismodell (21), das zweite Parameter umfasst, wobei die zweiten Parameter basierend auf einem Datensatz (75) vergangener Betriebsdaten oder Simulationsdaten (65) von einer Anzahl von Brennstoffzellen ermittelt sind.

7. Verfahren nach einem der vorhergehenden Ansprüche, wobei der zweite neuronale Prädiktor (20) zumindest ein zweites neuronales Netz (20_1, ..., 20_i) umfasst, das eine Gedächtnisfunktion enthält, beispielsweise LSTM, GRU oder Transformer, und eine Ausgangsschicht aufweist, wobei die Ausgangsschicht eine Wahrscheinlichkeitsverteilung für einen Alterungseinflusswert auf die Zellspannung der elektrochemischen Anlage repräsentiert.

8. Verfahren nach einem der vorhergehenden Ansprüche, wobei die Verknüpfung (15) der Ausgangswerte des ersten neuronalen Prädiktors (10) und des zweiten neuronalen Prädiktors (20) ein Addieren, Subtrahieren oder Multiplizieren des Ausgangswerts des ersten neuronalen Prädiktors (10) zu oder von dem Ausgangswert des zweiten neuronalen Prädiktors (20) umfasst.

**9.** Verfahren nach einem der vorhergehenden Ansprüche, ferner aufweisend:

Trainieren des ersten neuronalen Prädiktors (10) und/oder des zweiten neuronalen Prädiktors (20) ausgehend von dem jeweiligen Basismodell (11, 21) basierend auf den Trainingsdaten (50) durch eine Kreuzvalidierung, wobei die Kreuzvalidierung ein Trainieren einer Anzahl von neuronalen Netzen basierend auf jeweils einer Untermenge der Trainingsdaten (50) umfasst, wobei die Untermenge durch ein vorbestimmtes Verhältnis von Trainings- zu Validierungsdaten bestimmt ist, sodass der erste neuronale Prädiktor (10) und/oder der zweite neuronale Prädiktors (20) für jede Untermenge ein trainiertes neuronales Netz (10_1, ..., 10_i, 20_1, ..., 20_i) umfasst; und

Ermitteln des Ausgangswertes des ersten neuronalen Prädiktors (10) und/oder des zweiten neuronalen Prädiktors (20) durch Bilden eines Mittelwerts der Ausgangswerte der jeweiligen trainierten neuronalen Netze (10_1, ..., 10_i, 20_1, ..., 20_i).

**10.** Verfahren nach einem der vorhergehenden Ansprüche, wobei die Trainingsdaten (50) zwischen 15 und 1000 Datenpunkte, bevorzugt zwischen 35 und 200 Datenpunkte umfassen.

**11.** Verfahren zum Erkennen einer Anomalie in einem Betrieb einer elektrochemischen Anlage, insbesondere Brennstoffzelle, das Verfahren umfassend:

Erfassen (S3) einer Zellspannung der elektrochemischen Anlage;

Vorhersagen (S4) der Zellspannung der elektrochemischen Anlage basierend auf einem Überwachungsmodell (30), das gemäß einem der vorhergehenden Ansprüche bereitgestellt ist, vorzugsweise in Echtzeit; und

Vergleichen (S5) der erfassten Zellspannung mit der vorhergesagten Zellspannung, vorzugsweise in Echtzeit, wobei, falls die erfasste Zellspannung für ein vorbestimmtes Zeitintervall außerhalb eines vorbestimmten Bereichs um die vorhergesagte Zellspannung ist, Erkennen (S6) der Anomalie.

**12.** Verfahren nach einem der Ansprüche 11, wobei das Verfahren ferner umfasst:

Speichern der erfassten Zellspannung in Abhängigkeit der Betriebsbedingung;

Aufbereiten der gespeicherten Zellspannung und Betriebsbedingung nach einem vorbestimmten Intervall als Trainingsdaten (50) für den ersten neuronale Prädiktor (10) und/oder den zweiten neuronale Prädiktor (20); und

Bereitstellen eines angepassten Überwachungsmodells gemäß einem der Ansprüche 1-11.

**13.** Vorrichtung (1) zum Bereitstellen eines Überwachungsmodells zur Überwachung einer elektrochemischen Anlage, insbesondere Brennstoffzelle, wobei die Vorrichtung (1) eine Speichereinrichtung (2) und einen Prozessor (3) umfasst, wobei

in der Speichereinrichtung (2) erste Anweisungen zur Ausführung des ersten neuronalen Prädiktors (10) und zweite Anweisungen zur Ausführung des zweiten neuronalen Prädiktors (20) und jeweils ein Basismodell (11, 21) für den ersten neuronalen Prädiktor (10) und/oder den zweiten neuronalen Prädiktor (20) gespeichert sind; und

der Prozessor (3) eingerichtet ist, ein Verfahren nach einem der Ansprüche 1 bis 12 auszuführen, wodurch die ersten Anweisungen und die zweiten Anweisungen angepasst werden.

**14.** System zum Erkennen einer Anomalie in einem Betrieb einer elektrochemischen Anlage, insbesondere Brennstoffzelle, das System umfassend:

eine Datenerfassungseinrichtung (4), die eingerichtet ist, eine Zellspannung der elektrochemischen Anlage, vorzugsweise in Abhängigkeit der jeweiligen Betriebsbedingung, zu erfassen; und

eine Auswerteeinrichtung (1'), die eine Speichereinrichtung (2') und einen Prozessor (3') umfasst und eingerichtet ist, Daten von der Datenerfassungseinrichtung (4) zu empfangen und/oder abzufragen, wobei

in der Speichereinrichtung (2') Anweisungen zur Ausführung eines Überwachungsmodells (30), das gemäß einem der Ansprüche 1-12 bereitgestellt ist, gespeichert sind; und

der Prozessor (3') eingerichtet ist, ein Verfahren nach einem der Ansprüche 13 bis 15 unter Verwendung der Anweisungen auszuführen,

wobei das System vorzugsweise ferner eine zentrale Datenbankeinrichtung aufweist, wobei die Datenerfassungseinrichtung (4) ferner eingerichtet ist, die erfasste Zellspannung der elektrochemischen Anlage, vorzugsweise in Abhängigkeit der jeweiligen Betriebsbedingung, an die zentrale Datenbankeinrichtung zu übertragen, vorzugsweise in Echtzeit, und die Auswerteeinheit (1') eingerichtet ist, Daten von der zentralen Datenbankeinrichtung zu empfangen und/oder abzufragen.

**15.** Computerprogramm mit Programmcode-Mitteln, um ein Verfahren nach einem der Ansprüche 1 bis 12 durchzuführen, wenn das Programm auf einem Computer ausgeführt wird.

**Geänderte Patentansprüche gemäss Regel 137(2) EPÜ.**

**1.** Verfahren zum Bereitstellen eines Überwachungsmodells (30) zur Überwachung einer elektrochemischen Anlage insbesondere einer Brennstoffzelle, das Verfahren umfassend:

Erfassen von Betriebsdaten der elektrochemischen Anlage als Trainingsdaten (50);
Trainieren (S1) eines ersten neuronalen Prädiktors (10) basierend auf den Trainingsdaten (50) zum Vorhersagen einer Zellspannung, wobei der erste neuronale Prädiktor (10) einen stationären Betrieb der elektrochemischen Anlage repräsentiert;
Trainieren (S2) eines zweiten neuronalen Prädiktors (20) basierend auf den Trainingsdaten (50) zum Vorhersagen eines Alterungseinflusses auf die Zellspannung der elektrochemischen Anlage,
wobei der erste neuronale Prädiktor (10) und/oder der zweite neuronale Prädiktor (20) ausgehend von einem jeweiligen Basismodell (11, 21) mittels Transferlernen trainiert werden, wobei der erste neuronale Prädiktor (10) und der zweite neuronale Prädiktor (20) jeweils eingerichtet sind, einen Ausgangswert zu erzeugen; und
Bereitstellen des Überwachungsmodells (30), das den ersten neuronalen Prädiktor (10), den zweiten neuronalen Prädiktor (20) und eine Verknüpfung (15) derer Ausgangswerte umfasst.

**2.** Verfahren nach Anspruch 1, wobei das Verfahren ferner umfasst:
Trainieren (S1) des ersten neuronalen Prädiktors (10) ausgehend von einem ersten Basismodell (11), das erste Parameter umfasst, wobei die ersten Parameter basierend auf Realdaten (70) und/oder einer Simulation (60) der elektrochemischen Anlage ermittelt sind.

**3.** Verfahren nach Anspruch 2, wobei die elektrochemische Anlage eine Brennstoffzelle ist und mehrere Zellsegmente umfasst, wobei die Simulation (60) eingerichtet ist, für jedes Zellsegment eine Spannung basierend auf mehreren physikalischen Eingangsvariablen zu ermitteln, und eine Zellspannung der Brennstoffzelle basierend auf den Spannungen der Zellsegmente zu ermitteln.

**4.** Verfahren nach Anspruch 3, wobei die Simulation (60) eingerichtet ist, durch Abtasten von Werten für die mehreren physikalischen Eingangsvariablen Trainingsdaten (65) für eine Vielzahl von Betriebsbedingungen zum Ermitteln (S0) der ersten Parameter des ersten Basismodells (11) zu erzeugen, vorzugsweise durch einen gleichmäßig abgetasteten Strom oder durch eine gleichmäßige Verteilung der ermittelten Zellspannung.

**5.** Verfahren nach Anspruch 4, wobei die Trainingsdaten (65) mehrere Merkmalsvektoren umfassen, die jeweils einen Datenpunkt repräsentieren und eine vorbestimmte Anzahl physikalischer Eingangsmerkmale und ein dazu korrespondierender Spannungswert umfassen, wobei das Verfahren ferner umfasst: Erzeugen der physikalischen Eingangsmerkale durch Transformieren der physikalischen Eingangsvariablen der Simulation (60).

**6.** Verfahren nach einem der vorhergehenden Ansprüche, wobei das Verfahren ferner umfasst:

Trainieren (S2) des zweiten neuronalen Prädiktors (20) ausgehend von einem zweiten Basismodell (21), das zweite Parameter umfasst, wobei die zweiten Parameter basierend auf einem Datensatz (75) vergangener Betriebsdaten oder Simulationsdaten (65) von einer Anzahl von Brennstoffzellen ermittelt sind.

**7.** Verfahren nach einem der vorhergehenden Ansprüche, wobei der zweite neuronale Prädiktor (20) zumindest ein zweites neuronales Netz (20_1, ..., 20_i) umfasst, das eine Gedächtnisfunktion enthält, beispielsweise LSTM, GRU oder Transformer, und eine Ausgangsschicht aufweist, wobei die Ausgangsschicht eine Wahrscheinlichkeitsverteilung für einen Alterungseinflusswert auf die Zellspannung der elektrochemischen Anlage repräsentiert.

**8.** Verfahren nach einem der vorhergehenden Ansprüche, wobei die Verknüpfung (15) der Ausgangswerte des ersten neuronalen Prädiktors (10) und des zweiten neuronalen Prädiktors (20) ein Addieren, Subtrahieren oder Multiplizieren des Ausgangswerts des ersten neuronalen Prädiktors (10) zu oder von dem Ausgangswert des zweiten neuronalen Prädiktors (20) umfasst.

**9.** Verfahren nach einem der vorhergehenden Ansprüche, ferner aufweisend:

Trainieren des ersten neuronalen Prädiktors (10) und/oder des zweiten neuronalen Prädiktors (20) ausgehend von dem jeweiligen Basismodell (11, 21) basierend auf den Trainingsdaten (50) durch eine Kreuzvalidierung, wobei die Kreuzvalidierung ein Trainieren einer Anzahl von neuronalen Netzen basierend auf jeweils einer Untermenge der Trainingsdaten (50) umfasst, wobei die Untermenge durch ein vorbestimmtes Verhältnis von Trainings- zu Validierungsdaten bestimmt ist, sodass der erste neuronale Prädiktor (10) und/oder der zweite neuronale Prädiktors (20) für jede Untermenge ein trainiertes neuronales Netz (10_1, ..., 10_i, 20_1, ..., 20_i) umfasst; und

Ermitteln des Ausgangswertes des ersten neuronalen Prädiktors (10) und/oder des zweiten neuronalen Prädiktors (20) durch Bilden eines Mittelwerts der Ausgangswerte der jeweiligen trainierten neuronalen Netze (10_1, ..., 10_i, 20_1, ..., 20_i).

**10.** Verfahren nach einem der vorhergehenden Ansprüche, wobei die Trainingsdaten (50) zwischen 15 und 1000 Datenpunkte, bevorzugt zwischen 35 und 200 Datenpunkte umfassen.

**11.** Verfahren zum Erkennen einer Anomalie in einem Betrieb einer elektrochemischen Anlage, insbesondere Brennstoffzelle, das Verfahren umfassend:

Erfassen (S3) einer Zellspannung der elektrochemischen Anlage;

Vorhersagen (S4) der Zellspannung der elektrochemischen Anlage basierend auf einem Überwachungsmodell (30), das gemäß einem der vorhergehenden Ansprüche bereitgestellt ist, vorzugsweise in Echtzeit; und

Vergleichen (S5) der erfassten Zellspannung mit der vorhergesagten Zellspannung, vorzugsweise in Echtzeit, wobei, falls die erfasste Zellspannung für ein vorbestimmtes Zeitintervall außerhalb eines vorbestimmten Bereichs um die vorhergesagte Zellspannung ist, Erkennen (S6) der Anomalie.

**12.** Verfahren nach einem der Ansprüche 11, wobei das Verfahren ferner umfasst:

Speichern der erfassten Zellspannung in Abhängigkeit der Betriebsbedingung;

Aufbereiten der gespeicherten Zellspannung und Betriebsbedingung nach einem vorbestimmten Intervall als Trainingsdaten (50) für den ersten neuronale Prädiktor (10) und/oder den zweiten neuronale Prädiktor (20); und

Bereitstellen eines angepassten Überwachungsmodells gemäß einem der Ansprüche 1-11.

**13.** Vorrichtung (1) zum Bereitstellen eines Überwachungsmodells zur Überwachung einer elektrochemischen Anlage, insbesondere Brennstoffzelle, wobei die Vorrichtung (1) eine Speichereinrichtung (2) und einen Prozessor (3) umfasst, wobei

in der Speichereinrichtung (2) erste Anweisungen zur Ausführung des ersten neuronalen Prädiktors (10) und zweite Anweisungen zur Ausführung des zweiten neuronalen Prädiktors (20) und jeweils ein Basismodell (11, 21) für den ersten neuronalen Prädiktor (10) und/oder den zweiten neuronalen Prädiktor (20) gespeichert sind; und

der Prozessor (3) eingerichtet ist, ein Verfahren nach einem der Ansprüche 1 bis 12 auszuführen, wodurch die ersten Anweisungen und die zweiten Anweisungen angepasst werden.

**14.** System zum Erkennen einer Anomalie in einem Betrieb einer elektrochemischen Anlage, insbesondere Brennstoffzelle, das System umfassend:

eine Datenerfassungseinrichtung (4), die eingerichtet ist, eine Zellspannung der elektrochemischen Anlage, vorzugsweise in Abhängigkeit der jeweiligen Betriebsbedingung, zu erfassen; und

eine Auswerteeinrichtung (1'), die eine Speichereinrichtung (2') und einen Prozessor (3') umfasst und eingerichtet ist, Daten von der Datenerfassungseinrichtung (4) zu empfangen und/oder abzufragen, wobei

in der Speichereinrichtung (2') Anweisungen zur Ausführung eines Überwachungsmodells (30), das gemäß einem der Ansprüche 1-12 bereitgestellt ist, gespeichert sind; und

der Prozessor (3') eingerichtet ist, ein Verfahren nach einem der Ansprüche 13 bis 15 unter Verwendung der Anweisungen auszuführen,

wobei das System vorzugsweise ferner eine zentrale Datenbankeinrichtung aufweist, wobei die Datenerfassungseinrichtung (4) ferner eingerichtet ist, die erfasste Zellspannung der elektrochemischen Anlage, vorzugsweise in Abhängigkeit der jeweiligen Betriebsbedingung, an die zentrale Datenbankeinrichtung zu übertragen, vorzugsweise in Echtzeit, und die Auswerteeinheit (1') eingerichtet ist, Daten von der zentralen Datenbankeinrichtung zu empfangen und/oder abzufragen.

**15.** Computerprogramm mit Programmcode-Mitteln, um ein Verfahren nach einem der Ansprüche 1 bis 12 durchzuführen, wenn das Programm auf einem Computer ausgeführt wird.

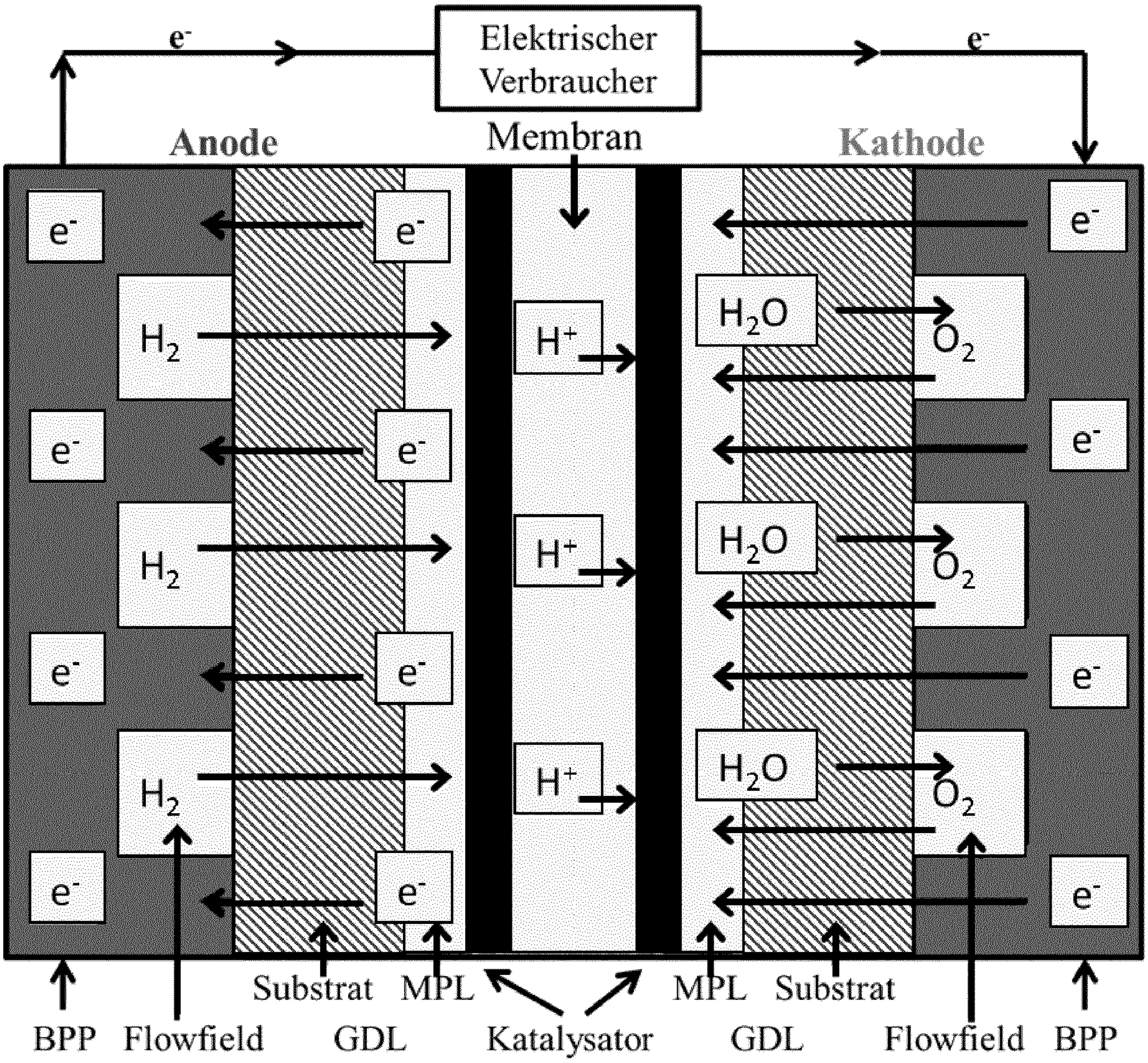
e-
e-
Elektrischer Verbraucher
Anode
Membran
Kathode
e-
e-
e-
e-
e-
e-
e-
e-
e-
e-
e-
e-
$H_2$
$H_2$
$H_2$
$H^+$
$H^+$
$H^+$
$H_2O$
$H_2O$
$H_2O$
$O_2$
$O_2$
$O_2$
Substrat
MPL
MPL
Substrat
BPP
Flowfield
GDL
Katalysator
GDL
Flowfield
BPP

Fig. 1

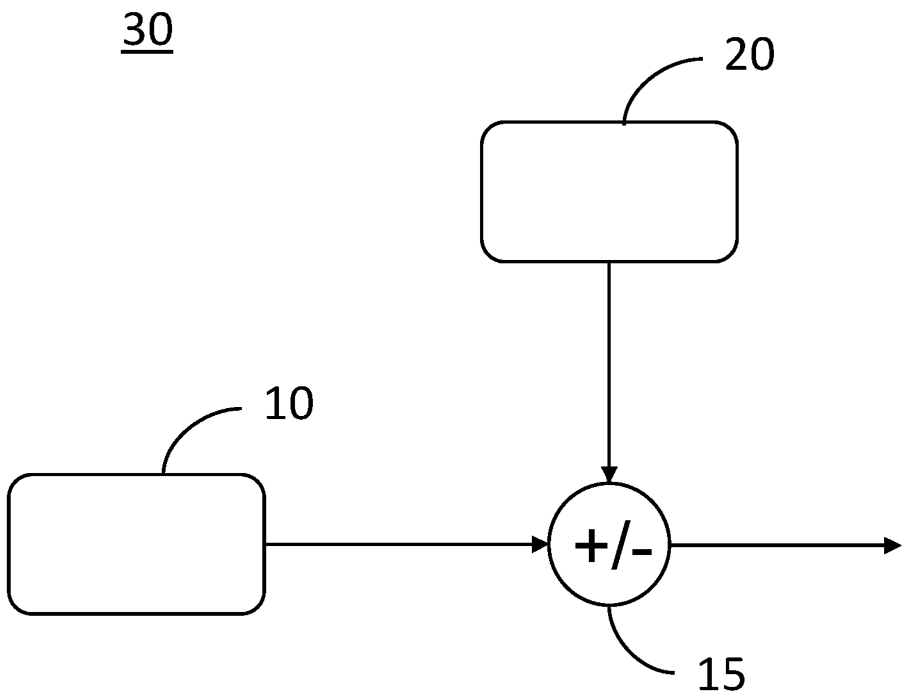
30
20
10
+/-
15

Fig. 2

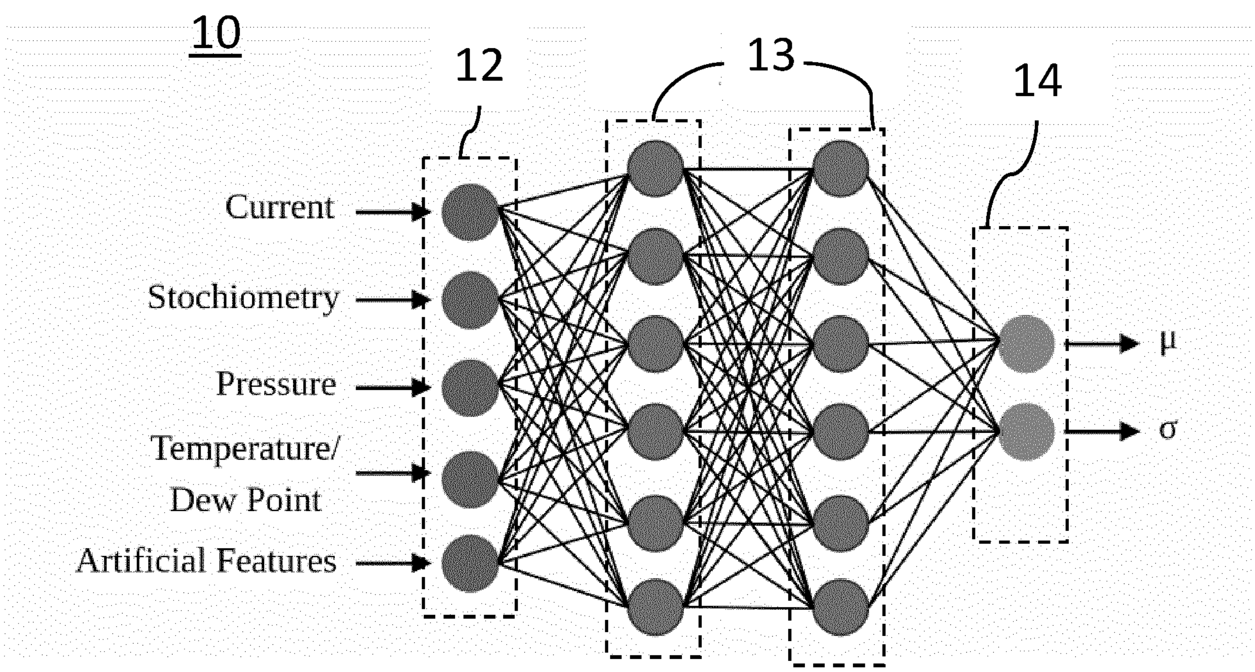
10
12
13
14
Current
Stochiometry
Pressure
Temperature/
Dew Point
Artificial Features
μ
σ

Fig. 3

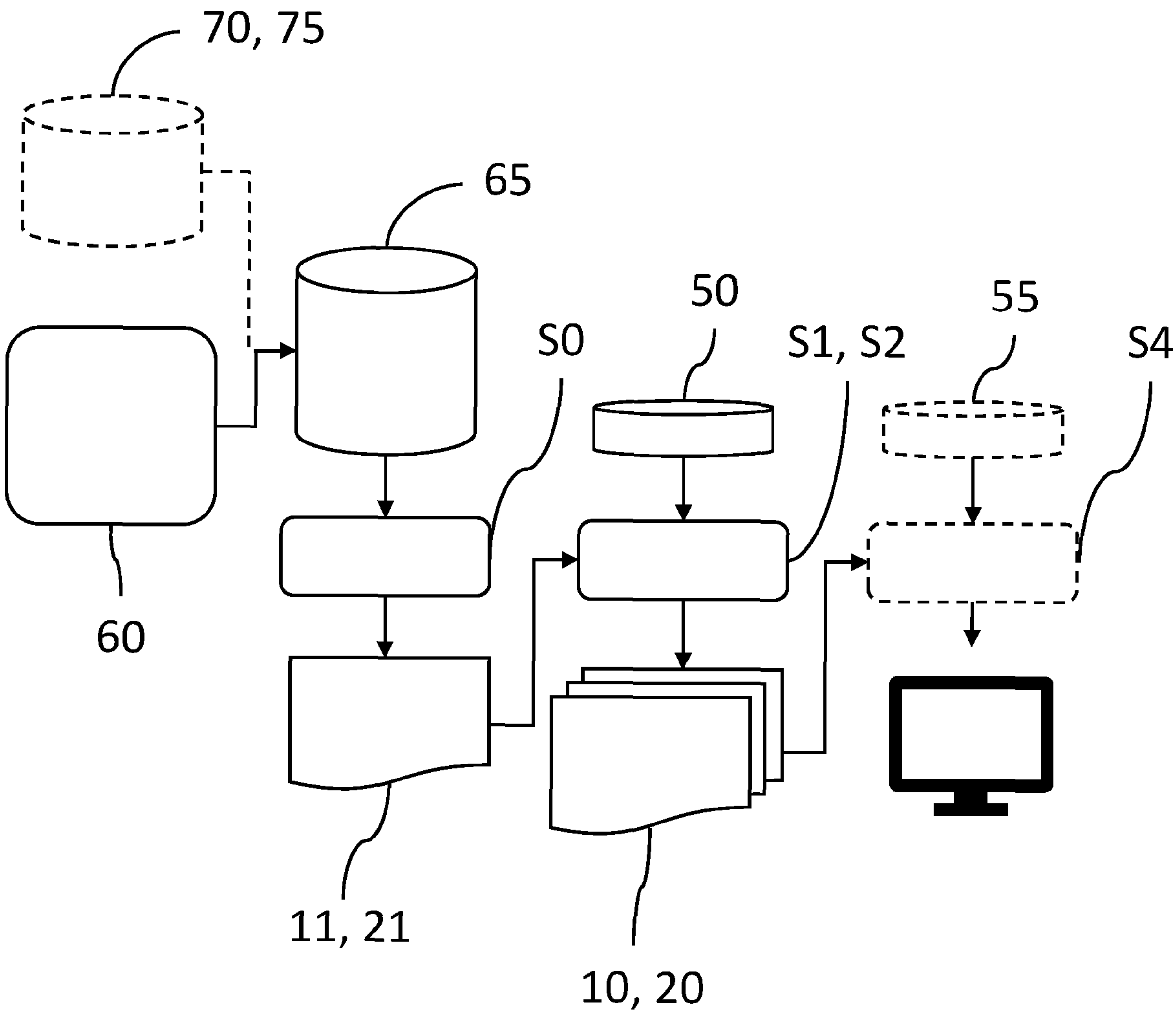


**Fig. 4**

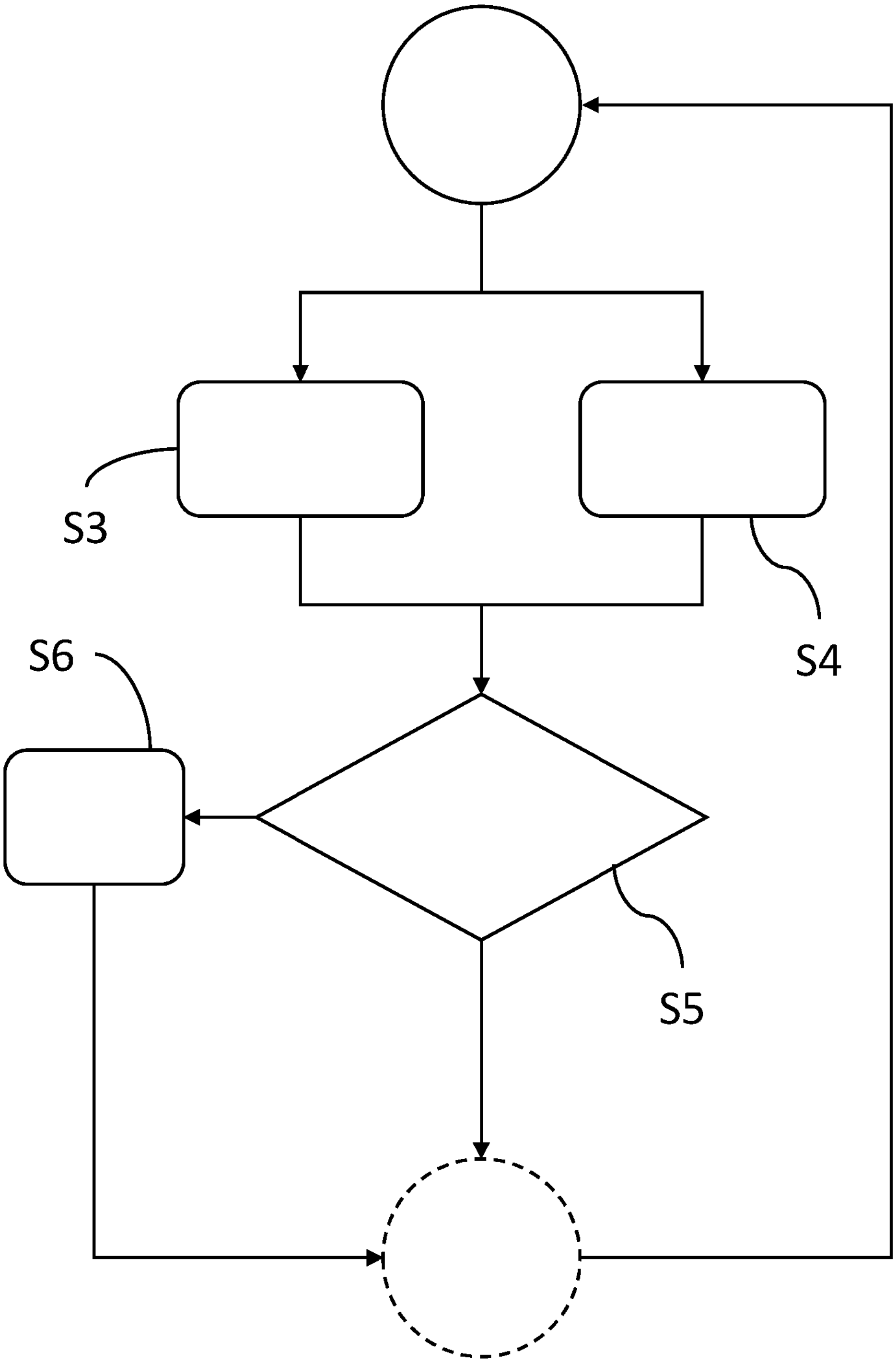


Fig. 5

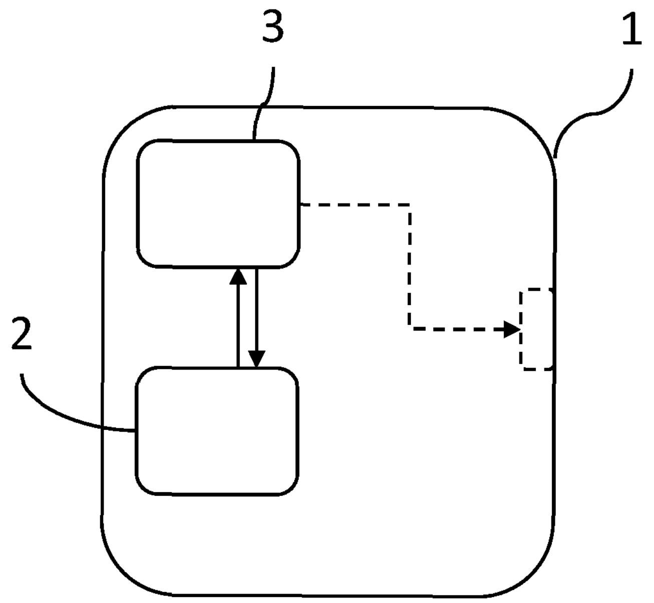


Fig. 6

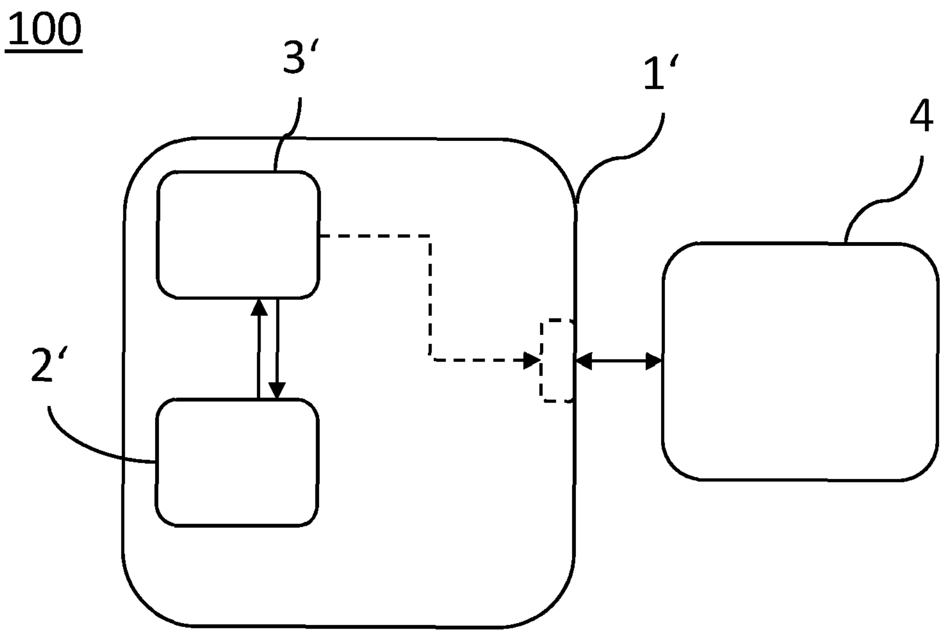


Fig. 7

Europäisches Patentamt
European Patent Office
Office européen des brevets

# EUROPÄISCHER RECHERCHENBERICHT

Nummer der Anmeldung
EP 24 20 3017

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | PEREZ LUIS ET AL: "A Data-Based Prognostic Technique of a Proton Exchange Membrane Fuel Cell Applying Dynamic Load Cycle", 2023 IEEE VEHICLE POWER AND PROPULSION CONFERENCE (VPPC), IEEE, 24. Oktober 2023 (2023-10-24), Seiten 1-6, XP034532136, DOI: 10.1109/VPPC60535.2023.10403161 [gefunden am 2024-01-30] * das ganze Dokument * ----- | 1-15 | INV. G01R31/367 G01R31/382 G01R31/392 H01M8/04298 H01M8/04537 H01M8/04664 H01M8/04992 |
| X | WU HANGYU ET AL: "Hybrid Physics-Based and Data-Driven Prognostic for PEM Fuel Cells Considering Voltage Recovery", IEEE TRANSACTIONS ON ENERGY CONVERSION, IEEE SERVICE CENTER, PISCATAWAY, NJ, US, Bd. 39, Nr. 1, 4. September 2023 (2023-09-04), Seiten 601-612, XP011961193, ISSN: 0885-8969, DOI: 10.1109/TEC.2023.3311460 [gefunden am 2023-09-04] * das ganze Dokument * ----- | 1-15 | RECHERCHIERTE SACHGEBIETE (IPC) |
| X | WANG FU-KWUN ET AL: "A Hybrid Method for Remaining Useful Life Prediction of Proton Exchange Membrane Fuel Cell Stack", IEEE ACCESS, IEEE, USA, Bd. 9, 9. März 2021 (2021-03-09), Seiten 40486-40495, XP011844220, DOI: 10.1109/ACCESS.2021.3064684 [gefunden am 2021-03-13] * das ganze Dokument * ----- -/-- | 1-15 | G01R H01M |

Der vorliegende Recherchenbericht wurde für alle Patentansprüche erstellt

1

| Recherchenort | Abschlußdatum der Recherche | Prüfer |
|---|---|---|
| München | 12. März 2025 | Bergado Colina, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Europäisches Patentamt
European Patent Office
Office européen des brevets

# EUROPÄISCHER RECHERCHENBERICHT

Nummer der Anmeldung
EP 24 20 3017

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | HUA ZHIGUANG ET AL: "A review on lifetime prediction of proton exchange membrane fuel cells system", JOURNAL OF POWER SOURCES, ELSEVIER, AMSTERDAM, NL, Bd. 529, 7. März 2022 (2022-03-07), XP086998403, ISSN: 0378-7753, DOI: 10.1016/J.JPOWSOUR.2022.231256 [gefunden am 2022-03-07] * das ganze Dokument * ----- | 1-15 | |
| X | LI WEI ET AL: "An LSTM and ANN Fusion Dynamic Model of a Proton Exchange Membrane Fuel Cell", IEEE TRANSACTIONS ON INDUSTRIAL INFORMATICS, IEEE SERVICE CENTER, NEW YORK, NY, US, Bd. 19, Nr. 4, 4. August 2022 (2022-08-04), Seiten 5743-5751, XP011937340, ISSN: 1551-3203, DOI: 10.1109/TII.2022.3196621 [gefunden am 2022-08-05] * das ganze Dokument * ----- | 1-15 | RECHERCHIERTE SACHGEBIETE (IPC) |
| | -/-- | | |

Der vorliegende Recherchenbericht wurde für alle Patentansprüche erstellt

1

| Recherchenort | Abschlußdatum der Recherche | Prüfer |
|---|---|---|
| München | 12. März 2025 | Bergado Colina, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

Europäisches Patentamt
European Patent Office
Office européen des brevets

# EUROPÄISCHER RECHERCHENBERICHT

Nummer der Anmeldung
EP 24 20 3017

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | MING WUYI ET AL: "A systematic review of machine learning methods applied to fuel cells in performance evaluation, durability prediction, and application monitoring", INTERNATIONAL JOURNAL OF HYDROGEN ENERGY, ELSEVIER, AMSTERDAM, NL, Bd. 48, Nr. 13, 28. November 2022 (2022-11-28), Seiten 5197-5228, XP087253631, ISSN: 0360-3199, DOI: 10.1016/J.IJHYDENE.2022.10.261 [gefunden am 2022-11-28] * das ganze Dokument * ----- | 1-15 | |
| X | YU YANG ET AL: "Deep learning with dual-stage attention mechanism for interpretable prediction of proton exchange membrane fuel cell performance degradation", INTERNATIONAL JOURNAL OF HYDROGEN ENERGY, ELSEVIER, AMSTERDAM, NL, Bd. 58, 30. Januar 2024 (2024-01-30), Seiten 902-911, XP087474271, ISSN: 0360-3199, DOI: 10.1016/J.IJHYDENE.2024.01.308 [gefunden am 2024-01-30] * das ganze Dokument * ----- | 1-15 | RECHERCHIERTE SACHGEBIETE (IPC) |
| X | CN 116 859 251 A (UNIV WUHAN TECH; STATE GRID ZHEJIANG ELECTRIC POWER CO LTD) 10. Oktober 2023 (2023-10-10) * das ganze Dokument * ----- | 1-15 | |
| X | CN 117 725 816 A (UNIV SOUTHERN SCI & TECH) 19. März 2024 (2024-03-19) * das ganze Dokument * ----- -/-- | 1-15 | |

Der vorliegende Recherchenbericht wurde für alle Patentansprüche erstellt

1

| Recherchenort | Abschlußdatum der Recherche | Prüfer |
|---|---|---|
| München | 12. März 2025 | Bergado Colina, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Seite 3 von 6

Europäisches Patentamt
European Patent Office
Office européen des brevets

# EUROPÄISCHER RECHERCHENBERICHT

Nummer der Anmeldung
EP 24 20 3017

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | CN 118 226 267 A (KINGLONG UNITED AUTOMOTIVE INDUSTRY SUZHOU CO LTD) 21. Juni 2024 (2024-06-21) * das ganze Dokument * ----- | 1-15 | |
| X | CN 111 428 913 A (UNIV SCIENCE & TECHNOLOGY CHINA) 17. Juli 2020 (2020-07-17) * das ganze Dokument * ----- | 1-15 | |
| X | US 2006/284617 A1 (KOZLOWSKI JAMES D [US] ET AL) 21. Dezember 2006 (2006-12-21) * Zusammenfassung * * Absatz [0033] - Absatz [0130]; Abbildungen 1-11 * ----- | 1-15 | |
| X | US 2024/210486 A1 (LAURENT SÉBASTIEN [FR] ET AL) 27. Juni 2024 (2024-06-27) * Zusammenfassung * * Absatz [0039] - Absatz [0169]; Abbildungen 1-3 * ----- | 1-15 | RECHERCHIERTE SACHGEBIETE (IPC) |
| X | DE 10 2021 208340 A1 (BOSCH GMBH ROBERT [DE]) 2. Februar 2023 (2023-02-02) * Zusammenfassung * * Absatz [0008] - Absatz [0044] * * Absatz [0051] - Absatz [0095]; Abbildungen 1-4 * ----- -/-- | 1-15 | |

Der vorliegende Recherchenbericht wurde für alle Patentansprüche erstellt

1

| Recherchenort | Abschlußdatum der Recherche | Prüfer |
|---|---|---|
| München | 12. März 2025 | Bergado Colina, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
& : Mitglied der gleichen Patentfamilie, übereinstimmendes Dokument

EPO FORM 1503 03.82 (P04C03)

Europäisches Patentamt
European Patent Office
Office européen des brevets

# EUROPÄISCHER RECHERCHENBERICHT

Nummer der Anmeldung
EP 24 20 3017

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | KLASS LUKAS ET AL: "Lifelong performance monitoring of PEM fuel cells using machine learning models", JOURNAL OF POWER SOURCES, ELSEVIER, AMSTERDAM, NL, Bd. 580, 18. Juni 2023 (2023-06-18), XP087377414, ISSN: 0378-7753, DOI: 10.1016/J.JPOWSOUR.2023.233308 [gefunden am 2023-06-18] * das ganze Dokument * ----- | 1-15 | |
| A | ASENSIO F J ET AL: "Analysis of electrochemical and thermal models and modeling techniques for polymer electrolyte membrane fuel cells", RENEWABLE AND SUSTAINABLE ENERGY REVIEWS, ELSEVIERS SCIENCE, NEW YORK, NY, US, Bd. 113, 27. Juli 2019 (2019-07-27), XP085790543, ISSN: 1364-0321, DOI: 10.1016/J.RSER.2019.109283 [gefunden am 2019-07-27] * das ganze Dokument * ----- | 1-15 | RECHERCHIERTE SACHGEBIETE (IPC) |
| A | HE WENBIN ET AL: "Progress in prediction of remaining useful life of hydrogen fuel cells based on deep learning", RENEWABLE AND SUSTAINABLE ENERGY REVIEWS, ELSEVIERS SCIENCE, NEW YORK, NY, US, Bd. 192, 20. Dezember 2023 (2023-12-20), XP087532471, ISSN: 1364-0321, DOI: 10.1016/J.RSER.2023.114193 [gefunden am 2023-12-20] * das ganze Dokument * ----- -/-- | 1-15 | |

Der vorliegende Recherchenbericht wurde für alle Patentansprüche erstellt

1

| Recherchenort | Abschlußdatum der Recherche | Prüfer |
|---|---|---|
| München | 12. März 2025 | Bergado Colina, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
..................................................
& : Mitglied der gleichen Patentfamilie, übereinstimmendes Dokument

EPO FORM 1503 03.82 (P04C03)

Europäisches Patentamt
European Patent Office
Office européen des brevets

# EUROPÄISCHER RECHERCHENBERICHT

Nummer der Anmeldung
EP 24 20 3017

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | LIU XIAOHUI ET AL: "Comparison of Degradation Prediction Methods for Proton Exchange Membrane Fuel Cell", 2023 PROGNOSTICS AND HEALTH MANAGEMENT CONFERENCE (PHM), IEEE, 31. Mai 2023 (2023-05-31), Seiten 152-158, XP034367083, DOI: 10.1109/PHM58589.2023.00038 [gefunden am 2023-06-28] * das ganze Dokument * ----- | 1-15 | |
| | | | RECHERCHIERTE SACHGEBIETE (IPC) |

Der vorliegende Recherchenbericht wurde für alle Patentansprüche erstellt

1

| Recherchenort | Abschlußdatum der Recherche | Prüfer |
|---|---|---|
| München | 12. März 2025 | Bergado Colina, J |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.............................................
& : Mitglied der gleichen Patentfamilie, übereinstimmendes Dokument

EPO FORM 1503 03.82 (P04C03)

Seite 6 von 6

## ANHANG ZUM EUROPÄISCHEN RECHERCHENBERICHT ÜBER DIE EUROPÄISCHE PATENTANMELDUNG NR.

EP 24 20 3017

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-03-2025

| Im Recherchenbericht angeführtes Patentdokument | Datum der Veröffentlichung | Mitglied(er) der Patentfamilie | Datum der Veröffentlichung |
|---|---|---|---|
| CN 116859251 A | 10-10-2023 | KEINE | |
| CN 117725816 A | 19-03-2024 | KEINE | |
| CN 118226267 A | 21-06-2024 | KEINE | |
| CN 111428913 A | 17-07-2020 | KEINE | |
| US 2006284617 A1 | 21-12-2006 | AU 2003215258 A1 | 09-09-2003 |
| | | US 2003184307 A1 | 02-10-2003 |
| | | US 2006284617 A1 | 21-12-2006 |
| | | WO 03071617 A2 | 28-08-2003 |
| US 2024210486 A1 | 27-06-2024 | EP 4330695 A1 | 06-03-2024 |
| | | US 2024210486 A1 | 27-06-2024 |
| | | WO 2022229516 A1 | 03-11-2022 |
| DE 102021208340 A1 | 02-02-2023 | CN 115701545 A | 10-02-2023 |
| | | DE 102021208340 A1 | 02-02-2023 |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Nicht-Patentliteratur


- **KLASS et al.** Lifelong performance monitoring of PEM fuel cells using machine learning models. *Journal of Power Sources*, 2023, vol. 580, ISSN 0378-7753, 233308